(19) Europäisches Patentamt
European Patent Office
Office européen des brevets

(11) **EP 4 672 724 A1**

(12) **EUROPEAN PATENT APPLICATION**
published in accordance with Art. 153(4) EPC

(43) Date of publication:
**31.12.2025 Bulletin 2026/01**

(21) Application number: **23933393.3**

(22) Date of filing: **18.04.2023**

(51) International Patent Classification (IPC):
**H04L 69/04** *(2022.01)*

(52) Cooperative Patent Classification (CPC):
**H04L 69/04**

(86) International application number:
**PCT/CN2023/089066**

(87) International publication number:
**WO 2024/216514 (24.10.2024 Gazette 2024/43)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **HUAWEI TECHNOLOGIES CO., LTD.
Shenzhen, Guangdong 518129 (CN)**

(72) Inventors:
- **TANG, Zihan
  Shenzhen, Guangdong 518129 (CN)**
- **MA, Mengyao
  Shenzhen, Guangdong 518129 (CN)**
- **PENG, Xiaohui
  Shenzhen, Guangdong 518129 (CN)**
- **DU, Yinggang
  Shenzhen, Guangdong 518129 (CN)**

(74) Representative: **Pfenning, Meinig & Partner mbB
Patent- und Rechtsanwälte
Theresienhöhe 11a
80339 München (DE)**

(54) **DATA COMPRESSION METHOD, DATA DECOMPRESSION METHOD, AND RELATED APPARATUS**

(57)    This application discloses a data compression method, a data decompression method, and a related apparatus. The method includes: performing compression coding on data in one or more dimensions in first data based on a first coding parameter, to obtain one or more pieces of compressed data; and sending second data, where the second data includes the compressed data and first indication information, and the first indication information indicates the first coding parameter. The first coding parameter satisfies a target condition, the target condition is that a code length obtained by performing compression coding on the data in the one or more dimensions in the first data based on the first coding parameter is a shortest one in a plurality of code lengths, the plurality of code lengths include code lengths obtained by performing compression coding on the data in the one or more dimensions in the first data separately based on a plurality of groups of coding parameters, and the plurality of groups of coding parameters include the first coding parameter. The method can improve data compression performance.

FIG. 5

## Description

### TECHNICAL FIELD

This application relates to the field of data compression, and in particular, to a data compression method, a data decompression method, and a related apparatus.

### BACKGROUND

Existing compression technologies for multi-dimensional data are mainly classified into two types: One is vector quantization (vector quantization, VQ), and the other is transform domain compression, for example, compression methods based on linear transformation such as discrete cosine transform (discrete cosine transform, DCT) and discrete wavelet transform (discrete wavelet transform, DWT), and nonlinear transform domain compression methods based on deep learning tools such as a variational autoencoder (variational auto encoder, VAE) and a flow-based generative model. VQ is an effective lossy compression technology newly developed in the late 1970s, and a theoretical basis of VQ is Shannon's rate-distortion theory. A basic principle of vector quantization is to replace an input vector with an index of a codeword that most matches the input vector and that is in a codebook for transmission and storage, and only a simple table lookup operation is needed during decoding. Significant advantages of VQ include a high compression ratio, simple decoding, and an ability of effectively preserve signal details. At present, compression technologies for multi-dimensional data are still a vibrant area of research.

### SUMMARY

Embodiments of this application disclose a data compression method, a data decompression method, and a related apparatus, to improve data compression performance and in particular multi-dimensional data compression performance.

According to a first aspect, an embodiment of this application provides a data compression method. The method includes: performing compression coding on data in one or more dimensions in first data based on a first coding parameter, to obtain one or more pieces of compressed data; and sending second data, where the second data includes the compressed data and first indication information, and the first indication information indicates the first coding parameter. The first coding parameter satisfies a target condition, the target condition is that a code length obtained by performing compression coding on the data in the one or more dimensions in the first data based on the first coding parameter is a shortest one in a plurality of code lengths, the plurality of code lengths include code lengths obtained by performing compression coding on the data in the one or more dimensions in the first data separately based on a plurality of groups of coding parameters, and the plurality of groups of coding parameters include the first coding parameter. The shortest one in the plurality of code lengths may be referred to as a first shortest code length, a shortest one in the plurality of code lengths other than the first shortest code length may be referred to as a second shortest code length, a shortest one in the plurality of code lengths other than the first shortest code length and the second shortest code length may be referred to as a third shortest code length, and so on. Alternatively, the target condition may be that a code length obtained by performing compression coding on the data in the one or more dimensions in the first data based on the first coding parameter is one of the second shortest code length, the third shortest code length, a fourth shortest code length, or the like among the plurality of code lengths. This is not limited in this application.

In this embodiment of this application, compression coding is performed on the data in the one or more dimensions in the first data based on the first coding parameter, to obtain the one or more pieces of compressed data; and the second data is sent, where the second data includes the compressed data and the first indication information. Because the first coding parameter satisfies the target condition, the code length obtained by performing compression coding on the data in the one or more dimensions in the first data based on the first coding parameter is the shortest. This can improve data compression performance. In addition, the sent second data includes the first indication information, so that a receiver decodes the compressed data in the second data based on the first coding parameter.

In a possible implementation, before the performing compression coding on the data in the one or more dimensions in the first data based on the first coding parameter, the method further includes: obtaining the plurality of code lengths obtained by performing compression coding on the data in the one or more dimensions in the first data separately based on the plurality of groups of coding parameters, where the plurality of groups of coding parameters are in one-to-one correspondence with the plurality of code lengths; and determining that the code length obtained by performing compression coding on the data in the one or more dimensions in the first data based on the first coding parameter is the shortest one in the plurality of code lengths. The method in the first aspect is performed by a transmitter. It should be noted that the transmitter can calculate the code length obtained by performing compression coding on the data in the one or more dimensions in the first data based on the first coding parameter, instead of performing compression coding on the data in the one or more dimensions in the first data based on the first coding parameter to obtain the code length. Alternatively, the transmitter can calculate the code length obtained by performing compression coding on the data in the one or more dimensions in the first data based on the first coding parameter, without obtaining the one or more groups of data.

In this implementation, it is determined that the code length obtained by performing compression coding on the data in the one or more dimensions in the first data based on the first coding parameter is the shortest one in the plurality of code lengths, to obtain an optimal coding parameter.

In a possible implementation, the first coding parameter is a Golomb code parameter.

In this implementation, the code length obtained by performing compression coding on the data in the one or more dimensions in the first data based on the first coding parameter can be calculated without performing a compression operation. This can reduce a data compression time.

In a possible implementation, the second data further includes k pieces of quantized cluster-center data, at least one of the one or more pieces of compressed data corresponds to one of the k pieces of quantized cluster-center data, and k is an integer greater than or equal to 1. For example, the k pieces of quantized cluster-center data are k bit strings with a fixed length, and each bit string represents one quantized value and corresponds to one cluster center. Each of the one or more pieces of compressed data may be corresponding to one of the k pieces of quantized cluster-center data. Optionally, the one or more pieces of compressed data are divided into k groups, and each group corresponds to one piece of quantized cluster-center data. In other words, the k groups of compressed data are in one-to-one correspondence with the k pieces of quantized cluster-center data.

In this implementation, the second data further includes the k pieces of quantized cluster-center data, so that a dynamic aggregation feature of the data can be effectively utilized for compression.

In a possible implementation, the second data further includes second indication information, and the second indication information identifies a correspondence between the k pieces of quantized cluster-center data and the one or more pieces of compressed data.

In this implementation, the receiver can learn the correspondence between the k pieces of quantized cluster-center data and the one or more pieces of compressed data.

In a possible implementation, the second data further includes third indication information, and the third indication information indicates k.

In this implementation, the receiver can learn a quantity of quantized cluster-center data.

In a possible implementation, the second data includes first coding information and second coding information, the first coding information includes data in a first dimension in the one or more pieces of compressed data, the second coding information includes data in a second dimension in the one or more pieces of compressed data, the data in the first dimension in the one or more pieces of compressed data is obtained by performing compression coding based on data in the first dimension in the first data and a coding parameter in the first dimension in the first coding parameter, and the data in the second dimension in the one or more pieces of compressed data is obtained by performing compression coding based on data in the second dimension in the first data and a coding parameter in the second dimension in the first coding parameter.

In this implementation, the second data includes the first coding information and the second coding information. Because data in a same dimension in the one or more pieces of compressed data is located in same information, a data compression speed and a data decompression speed can be improved.

In a possible implementation, first compressed data in the one or more pieces of compressed data corresponds to first quantized cluster-center data in the k pieces of quantized cluster-center data, the first coding information includes data in the first dimension in the first compressed data, the data in the first dimension in the first compressed data is obtained by performing compression coding on a first quantized value by using the coding parameter in the first dimension in the first coding parameter, the first quantized value is obtained by quantizing a first difference, and the first difference is a difference between data that is in the first dimension in the first data and that corresponds to an element of the first quantized cluster-center data and data in the first dimension in the first quantized cluster-center data.

In a possible implementation, the performing compression coding on the data in the one or more dimensions in the first data based on the first coding parameter, to obtain the one or more pieces of compressed data includes: determining that a code length of compressed data obtained by performing the compression coding on the first data based on to-be-compressed information corresponding to a first clustering result and the first coding parameter is the shortest one in the plurality of code lengths. The first clustering result is a clustering result of an element in the first data, the to-be-compressed information includes a plurality of nonnegative integers obtained by mapping a plurality of quantized values, and the plurality of quantized values are obtained by quantizing a difference of each element in the first data relative to quantized cluster-center data corresponding to the element in the first clustering result. The determining that the code length of the compressed data obtained by performing the compression coding on the first data based on the to-be-compressed information corresponding to the first clustering result and the first coding parameter is the shortest one in the plurality of code lengths can be understood as performing (joint) optimization on the clustering result and the coding parameter to obtain an optimal coding parameter.

In this implementation, the coding parameter of the shortest code length can be obtained by performing compression coding on the first data.

In a possible implementation, the one or more pieces of compressed data include f pieces of compressed data in a third dimension and g pieces of compressed data in a fourth dimension, the f pieces of compressed data in the third dimension and the g pieces of compressed data in the fourth dimension are obtained by using different compression coding schemes, and f and g are integers greater than 0. That the f pieces of compressed data in the third dimension and the g pieces of compressed data in the fourth dimension are obtained by using different compression coding schemes may be that the f pieces of compressed data in the third dimension and the g pieces of compressed data in the fourth dimension are corresponding to different coding parameters and/or compression coding processes.

In this implementation, the f pieces of compressed data in the third dimension and the g pieces of compressed data in the fourth dimension are obtained by using different compression coding schemes. This implementation is applicable to a compression scenario in which data in the third dimension and data in the fourth dimension have different features.

In a possible implementation, the second data further includes fourth indication information, and the fourth indication information indicates a correspondence between compressed data in the third dimension and compressed data in the fourth dimension.

In this implementation, the receiver can combine data in the third dimension and data in the fourth dimension that are obtained through decompression into two-dimensional data based on the correspondence between compressed data in the third dimension and compressed data in the fourth dimension.

In a possible implementation, the second data further includes one or more cluster centers corresponding to the g pieces of compressed data in the fourth dimension, the f pieces of compressed data in the third dimension in the second data are sequentially arranged, the fourth indication information indicates the compressed data in the third dimension corresponding to the one or more cluster centers, and an order of entropy-coded data that is in the g pieces of compressed data in the fourth dimension and that corresponds to a same cluster center is the same as an order of data in the third dimension corresponding to the entropy-coded data.

In this implementation, the second data further includes the one or more cluster centers corresponding to the g pieces of compressed data in the fourth dimension, so that a dynamic aggregation feature of the data in the fourth dimension can be effectively utilized for compression. In addition, the fourth indication information indicates the compressed data in the third dimension corresponding to the one or more cluster centers, the f pieces of compressed data in the third dimension in the second data are sequentially arranged, and the order of the entropy-coded data that is in the g pieces of compressed data in the fourth dimension and that corresponds to the same cluster center is the same as the order of the data in the third dimension corresponding to the entropy-coded data. In this way, the receiver can determine the correspondence between compressed data in the third dimension and compressed data in the fourth dimension, and signaling overheads are low.

In a possible implementation, the fourth indication information includes a bitmap, a quantity of bits in the bitmap is equal to f, the bits in the bitmap are sequentially corresponding to the f pieces of sequentially arranged compressed data in the third dimension, any bit in the bitmap indicates whether compressed data in the fourth dimension corresponding to compressed data in the third dimension corresponding to the any bit belongs to a first cluster center, and the first cluster center is one of the plurality of cluster centers.

In this implementation, any bit in the bitmap indicates whether compressed data in the fourth dimension corresponding to compressed data in the third dimension corresponding to the any bit belongs to the first cluster center. This can reduce signaling overheads.

In a possible implementation, the one or more pieces of compressed data include t pieces of sequentially arranged data in a fifth dimension, the second data further includes a second quantized value, the second quantized value is obtained by quantizing minimum or maximum data in the fifth dimension in the first data, the t pieces of sequentially arranged data in the fifth dimension are obtained based on a difference obtained by performing differencing on sequentially arranged data in the fifth dimension in the first data, and t is an integer greater than or equal to 2.

In this implementation, differencing is performed on the t pieces of sequentially arranged data in the fifth dimension, and then the obtained difference is quantized. This can improve compression performance.

In a possible implementation, the second data further includes fifth indication information, and the fifth indication information indicates t.

In a possible implementation, the one or more pieces of compressed data further include t pieces of sequentially arranged data in a sixth dimension, the t pieces of sequentially arranged data in the sixth dimension are obtained based on a plurality of differences obtained by performing periodic differencing on data in the sixth dimension in the first data, the second data further includes a third quantized value, and the third quantized value is obtained by quantizing one of two pieces of data that are in the data in the sixth dimension and that yield a maximum difference through differencing.

In this implementation, differencing is performed on the t pieces of sequentially arranged data in the sixth dimension, and then the obtained difference is quantized. This can improve compression performance.

In a possible implementation, the second data further includes sixth indication information, and the sixth indication information indicates a correspondence between the t pieces of data in the fifth dimension and the t pieces of data in the sixth dimension.

In this implementation, the sixth indication information indicates the correspondence between the t pieces of data in the fifth dimension and the t pieces of data in the sixth dimension, so that the receiver combines the t pieces of data in the fifth dimension and the t pieces of data in the sixth dimension into t pieces of two-dimensional data based on the correspondence.

According to a second aspect, this application provides a data decompression method. The method includes: receiving second data, where the second data includes one or more pieces of compressed data and first indication information, the first indication information indicates a first coding parameter, the first coding parameter satisfies a target condition, the target condition is that a code length obtained by performing compression coding on data in one or more dimensions in first data based on the first coding parameter is a shortest one in a plurality of code lengths, the plurality of code lengths include code lengths obtained by performing compression coding on the data in the one or more dimensions in the first data separately based on a plurality of groups of coding parameters, and the plurality of groups of coding parameters include the first coding parameter; and decoding the compressed data in the second data based on the first entropy coding parameter, to obtain the first data. The shortest one in the plurality of code lengths may be referred to as a first shortest code length, a shortest one in the plurality of code lengths other than the first shortest code length may be referred to as a second shortest code length, a shortest one in the plurality of code lengths other than the first shortest code length and the second shortest code length may be referred to as a third shortest code length, and so on. Alternatively, the target condition may be that a code length obtained by performing compression coding on the data in the one or more dimensions in the first data based on the first coding parameter is one of the second shortest code length, the third shortest code length, a fourth shortest code length, or the like among the plurality of code lengths. This is not limited in this application.

In this embodiment of this application, the compressed data in the second data is decoded based on the first entropy coding parameter. Because the first coding parameter satisfies the target condition, the code length obtained by performing compression coding on the data in the one or more dimensions in the first data based on the first coding parameter is the shortest. This can improve data compression performance.

In a possible implementation, the first coding parameter is a Golomb code parameter.

In this implementation, the code length obtained by performing compression coding on the data in the one or more dimensions in the first data based on the first coding parameter can be calculated without performing a compression operation. This can reduce a data compression time.

In a possible implementation, the second data further includes k pieces of quantized cluster-center data, at least one of the one or more pieces of compressed data corresponds to one of the k pieces of quantized cluster-center data, and k is an integer greater than or equal to 1. For example, the k pieces of quantized cluster-center data are k bit strings with a fixed length, and each bit string represents one quantized value and corresponds to one cluster center. Each of the one or more pieces of compressed data may be corresponding to one of the k pieces of quantized cluster-center data. Optionally, the one or more pieces of compressed data are divided into k groups, and each group corresponds to one piece of quantized cluster-center data. In other words, the k groups of compressed data are in one-to-one correspondence with the k pieces of quantized cluster-center data.

In this implementation, the second data further includes the k pieces of quantized cluster-center data, so that a dynamic aggregation feature of the data can be effectively utilized for compression.

In a possible implementation, the second data further includes second indication information, and the second indication information identifies a correspondence between the k pieces of quantized cluster-center data and the one or more pieces of compressed data.

In this implementation, a receiver can learn the correspondence between the k pieces of quantized cluster-center data and the one or more pieces of compressed data.

In a possible implementation, the second data further includes third indication information, and the third indication information indicates k.

In this implementation, the receiver can learn a quantity of quantized cluster-center data.

In a possible implementation, the second data includes first coding information and second coding information, the first coding information includes data in a first dimension in the one or more pieces of compressed data, the second coding information includes data in a second dimension in the one or more pieces of compressed data, the data in the first dimension in the one or more pieces of compressed data is obtained by performing compression coding based on data in the first dimension in the first data and a coding parameter in the first dimension in the first coding parameter, and the data in the second dimension in the one or more pieces of compressed data is obtained by performing compression coding based on data in the second dimension in the first data and a coding parameter in the second dimension in the first coding parameter.

In this implementation, the second data includes the first coding information and the second coding information. Because data in a same dimension in the one or more pieces of compressed data is located in same information, a data compression speed and a data decompression speed can be improved.

In a possible implementation, first compressed data in the one or more pieces of compressed data corresponds to first quantized cluster-center data in the k pieces of quantized cluster-center data, the first coding information includes data in the first dimension in the first compressed data, the data in the first dimension in the first compressed data is obtained by performing compression coding on a first quantized value by using the coding parameter in the first dimension in the first coding parameter, the first quantized value is obtained by quantizing a first difference, and the first difference is a difference between data that is in the first dimension in the first data and that corresponds to an element of the first quantized cluster-center data and data in the first dimension in the first quantized cluster-center data.

In a possible implementation, the performing compression coding on the data in the one or more dimensions in the first data based on the first coding parameter, to obtain the one or more pieces of compressed data includes: determining that a code length of compressed data obtained by performing the compression coding on the first data based on to-be-compressed information corresponding to a first clustering result and the first coding parameter is the shortest one in the plurality of code lengths. The first clustering result is a clustering result of an element in the first data, the to-be-compressed information includes a plurality of nonnegative integers obtained by mapping a plurality of quantized values, and the plurality of quantized values are obtained by quantizing a difference of each element in the first data relative to quantized cluster-center data corresponding to the element in the first clustering result. The determining that the code length of the compressed data obtained by performing the compression coding on the first data based on the to-be-compressed information corresponding to the first clustering result and the first coding parameter is the shortest one in the plurality of code lengths can be understood as performing (joint) optimization on the clustering result and the coding parameter to obtain an optimal coding parameter.

In this implementation, the coding parameter of the shortest code length can be obtained by performing compression coding on the first data.

In a possible implementation, the one or more pieces of compressed data include f pieces of compressed data in a third dimension and g pieces of compressed data in a fourth dimension, the f pieces of compressed data in the third dimension and the g pieces of compressed data in the fourth dimension are obtained by using different compression coding schemes, and f and g are integers greater than 0.

In this implementation, the f pieces of compressed data in the third dimension and the g pieces of compressed data in the fourth dimension are obtained by using different compression coding schemes. This implementation is applicable to a compression scenario in which data in the third dimension and data in the fourth dimension have different features.

In a possible implementation, the second data further includes fourth indication information, and the fourth indication information indicates a correspondence between compressed data in the third dimension and compressed data in the fourth dimension.

In this implementation, the receiver can combine data in the third dimension and data in the fourth dimension that are obtained through decompression into two-dimensional data based on the correspondence between compressed data in the third dimension and compressed data in the fourth dimension.

In a possible implementation, the second data further includes one or more cluster centers corresponding to the g pieces of compressed data in the fourth dimension, the f pieces of compressed data in the third dimension in the second data are sequentially arranged, the fourth indication information indicates the compressed data in the third dimension corresponding to the one or more cluster centers, and an order of entropy-coded data that is in the g pieces of compressed data in the fourth dimension and that corresponds to a same cluster center is the same as an order of data in the third dimension corresponding to the entropy-coded data.

In this implementation, the second data further includes the one or more cluster centers corresponding to the g pieces of compressed data in the fourth dimension, so that a dynamic aggregation feature of the data in the fourth dimension can be effectively utilized for compression. In addition, the fourth indication information indicates the compressed data in the third dimension corresponding to the one or more cluster centers, the f pieces of compressed data in the third dimension in the second data are sequentially arranged, and the order of the entropy-coded data that is in the g pieces of compressed data in the fourth dimension and that corresponds to the same cluster center is the same as the order of the data in the third dimension corresponding to the entropy-coded data. In this way, the receiver can determine the correspondence between compressed data in the third dimension and compressed data in the fourth dimension, and signaling overheads are low.

In a possible implementation, the fourth indication information includes a bitmap, a quantity of bits in the bitmap is equal to f, the bits in the bitmap are sequentially corresponding to the f pieces of sequentially arranged compressed data in the third dimension, any bit in the bitmap indicates whether compressed data in the fourth dimension corresponding to compressed data in the third dimension corresponding to the any bit belongs to a first cluster center, and the first cluster center is one of the plurality of cluster centers.

In this implementation, any bit in the bitmap indicates whether compressed data in the fourth dimension corresponding to compressed data in the third dimension corresponding to the any bit belongs to the first cluster center. This can reduce signaling overheads.

In a possible implementation, the one or more pieces of compressed data include t pieces of sequentially arranged data in a fifth dimension, the second data further includes a second quantized value, the second quantized value is obtained by quantizing minimum or maximum data in the fifth dimension in the first data, the t pieces of sequentially arranged data in the fifth dimension are obtained based on a difference obtained by performing differencing on sequentially arranged data in the fifth dimension in the first data, and t is an integer greater than or equal to 2.

In this implementation, differencing is performed on the t pieces of sequentially arranged data in the fifth dimension, and then the obtained difference is quantized. This can improve compression performance.

In a possible implementation, the second data further includes fifth indication information, and the fifth indication information indicates t.

In a possible implementation, the one or more pieces of compressed data further include t pieces of sequentially arranged data in a sixth dimension, the t pieces of sequentially arranged data in the sixth dimension are obtained based on a plurality of differences obtained by performing periodic differencing on data in the sixth dimension in the first data, the second data further includes a third quantized value, and the third quantized value is obtained by quantizing one of two pieces of data that are in the data in the sixth dimension and that yield a maximum difference through differencing.

In this implementation, differencing is performed on the t pieces of sequentially arranged data in the sixth dimension, and then the obtained difference is quantized. This can improve compression performance.

In a possible implementation, the second data further includes sixth indication information, and the sixth indication information indicates a correspondence between the t pieces of data in the fifth dimension and the t pieces of data in the sixth dimension.

In this implementation, the sixth indication information indicates the correspondence between the t pieces of data in the fifth dimension and the t pieces of data in the sixth dimension, so that the receiver combines the t pieces of data in the fifth dimension and the t pieces of data in the sixth dimension into t pieces of two-dimensional data based on the correspondence.

According to a third aspect, an embodiment of this application provides a data processing apparatus. The data processing apparatus has functions of implementing behaviors in the method embodiment in the first aspect. The data processing apparatus may be a communication device, may be a component (for example, a processor, a chip, or a chip system) of the communication device, or may be a logical module or software that can implement all or some functions of the communication device. The functions of the data processing apparatus may be implemented by using hardware, or may be implemented by hardware by executing corresponding software. The hardware or the software includes one or more modules or units corresponding to the foregoing functions. In a possible implementation, the data processing apparatus includes a transceiver module and a processing module. The processing module is configured to perform compression coding on data in one or more dimensions in first data based on a first coding parameter, to obtain one or more pieces of compressed data; and the transceiver module is configured to send second data, where the second data includes the compressed data and first indication information, and the first indication information indicate the first coding parameter. The first coding parameter satisfies a target condition, the target condition is that a code length obtained by performing compression coding on the data in the one or more dimensions in the first data based on the first coding parameter is a shortest one in a plurality of code lengths, the plurality of code lengths include code lengths obtained by performing compression coding on the data in the one or more dimensions in the first data separately based on a plurality of groups of coding parameters, and the plurality of groups of coding parameters include the first coding parameter.

In a possible implementation, the processing module is further configured to: obtain the plurality of code lengths obtained by performing compression coding on the data in the one or more dimensions in the first data separately based on the plurality of groups of coding parameters, where the plurality of groups of coding parameters are in one-to-one correspondence with the plurality of code lengths; and determine that the code length obtained by performing compression coding on the data in the one or more dimensions in the first data based on the first coding parameter is the shortest one in the plurality of code lengths.

In a possible implementation, the processing module is specifically configured to determine that a code length of compressed data obtained by performing the compression coding on the first data based on to-be-compressed information corresponding to a first clustering result and the first coding parameter is the shortest one in the plurality of code lengths. The first clustering result is a clustering result of an element in the first data, the to-be-compressed information includes a plurality of nonnegative integers obtained by mapping a plurality of quantized values, and the plurality of quantized values are obtained by quantizing a difference of each element in the first data relative to quantized cluster-center data corresponding to the element in the first clustering result.

For technical effects achieved by the possible implementations of the third aspect, refer to descriptions of the technical effect of the first aspect or the possible implementations of the first aspect.

According to a fourth aspect, an embodiment of this application provides a data processing apparatus. The data processing apparatus has functions of implementing behaviors in the method embodiment in the second aspect. The data processing apparatus may be a communication device, may be a component (for example, a processor, a chip, or a chip system) of the communication device, or may be a logical module or software that can implement all or some functions of the communication device. The functions of the data processing apparatus may be implemented by using hardware, or may be implemented by hardware by executing corresponding software. The hardware or the software includes one or more modules or units corresponding to the foregoing functions. In a possible implementation, the data processing apparatus includes a transceiver module and a processing module. The transceiver module is configured to receive second data, where the second data includes one or more pieces of compressed data and first indication information, the first indication information indicates a first coding parameter, the first coding parameter satisfies a target condition, the target condition is that a code length obtained by performing compression coding on data in one or more dimensions in first data based on the first coding parameter is a shortest one in a plurality of code lengths, the plurality of code lengths include code lengths obtained by performing compression coding on the data in the one or more dimensions in the first data separately based on a plurality of groups of coding parameters, and the plurality of groups of coding parameters include the first coding parameter; and the processing module is configured to decode the compressed data in the second data based on the first entropy coding parameter, to obtain the first data.

For technical effects achieved by the possible implementations of the fourth aspect, refer to descriptions of the technical effect of the second aspect or the possible implementations of the second aspect.

According to a fifth aspect, an embodiment of this application provides another data processing apparatus. The data processing includes a processor, the processor is coupled to a memory, and the memory is configured to store a program or instructions. When the program or instructions are executed by the processor, the method according to any possible implementation of the first aspect or the second aspect is performed.

In this embodiment of this application, in a process of performing the method, a process of sending information (or a signal) in the method can be understood as a process of outputting information based on instructions of the processor. When outputting the information, the processor outputs the information to a transceiver, so that the transceiver transmits the information. After the information is output by the processor, other processing may further need to be performed on the information, and then processed information arrives at the transceiver. Similarly, when the processor receives input information, the transceiver receives the information, and inputs the information into the processor. Further, after the transceiver receives the information, other processing may need to be performed on the information, and then processed information is input into the processor.

Sending, receiving, and/or other operations related to the processor can be generally understood as instruction outputting based on the processor, unless otherwise specified or the operations contradict actual functions or internal logic of the operations in related descriptions.

In an implementation process, the processor may be a processor specially configured to perform these methods, or a processor, for example, a general-purpose processor, that executes computer instructions in a memory to perform these methods. For example, the processor may be further configured to execute a program stored in the memory. When the program is executed, the data processing apparatus is enabled to perform the method according to any one of the first aspect or the possible implementations of the first aspect.

In a possible implementation, the memory is located outside the data processing apparatus. In a possible implementation, the memory is located inside the data processing apparatus.

In a possible implementation, the processor and the memory may be alternatively integrated into one component. In other words, the processor and the memory may be alternatively integrated together.

In a possible implementation, the data processing apparatus further includes a transceiver. The transceiver is configured to receive a signal, send a signal, or the like.

According to a sixth aspect, this application provides another data processing apparatus. The communication apparatus includes a processing circuit and an interface circuit. The interface circuit is configured to obtain data or output data. The processing circuit is configured to perform the corresponding method according to any possible implementation of the first aspect or the second aspect.

According to a seventh aspect, this application provides a computer-readable storage medium. The computer-readable storage medium stores a computer program, and the computer program includes program instructions. When the program instructions are executed, a computer is enabled to perform the method according to any possible implementation of the first aspect or the second aspect.

According to an eighth aspect, this application provides a computer program product. The computer program product includes a computer program, and the computer program includes program instructions. When the program instructions are executed, a computer is enabled to perform the method according to any possible implementation of the first aspect or the second aspect.

According to a ninth aspect, this application provides a communication system. The communication system includes the data processing apparatus according to any one of the third aspect or the possible implementations of the third aspect or a data processing apparatus that implements functions of the transmitter in embodiments of this application, and the data processing apparatus according to any one of the fourth aspect or the possible implementations of the fourth aspect or a data processing apparatus that implements functions of the receiver in embodiments of this application.

According to a tenth aspect, an embodiment of this application provides a chip, including a processor and a communication interface. The processor reads, by using the communication interface, instructions stored in a memory, to perform the method according to any one of the first aspect and the second aspect.

## BRIEF DESCRIPTION OF DRAWINGS

To describe technical solutions in embodiments of this application or in the background more clearly, the following describes accompanying drawings used in embodiments of this application or the background.

FIG. 1 is a principle diagram of each path in ray tracing according to an embodiment of this application;

FIG. 2 is a diagram of definitions of horizontal angles and vertical angles of an angle of departure/an angle of arrival according to an embodiment of this application;

FIG. 3 shows an example of angle data in ray tracing;

FIG. 4 is a diagram of an architecture of a communication system 1000 to which an embodiment of this application is applied;

FIG. 5 is a flowchart of a data compression transmission interaction method according to an embodiment of this application;

FIG. 6 is a flowchart of another data compression transmission interaction method according to an embodiment of this application;

FIG. 7 shows an example of approximation of an actual data distribution using a geometric distribution with a parameter p;

FIG. 8 shows an example of second data according to an embodiment of this application;

FIG. 9 is a flowchart of another data compression transmission interaction method according to an embodiment of this application;

FIG. 10 is a diagram of a code length obtained by calculating a compressed two-dimensional difference according to an embodiment of this application;

FIG. 11 shows an example of indication of a correspondence between data in different dimensions according to an embodiment of this application;

FIG. 12 is a flowchart of another data compression transmission interaction method according to an embodiment of this application;

FIG. 13 is a flowchart of another data compression transmission interaction method according to an embodiment of this application;

FIG. 14 shows another example of second data according to an embodiment of this application;

FIG. 15 is a diagram of angles of arrival of three paths;

FIG. 16 is a diagram of differential compression of horizontal angles of arrival;

FIG. 17 is a diagram of differential compression of vertical angles of arrival;

FIG. 18 is a flowchart of another data compression transmission interaction method according to an embodiment of this application;

FIG. 19 shows compression effect of an adaptive arithmetic coding scheme;

FIG. 20 shows compression effect of a Huffman coding scheme;

FIG. 21 shows compression effect of a clustering+Golomb joint optimization coding scheme;

FIG. 22 shows compression effect of compressing different quantities of paths;

FIG. 23 is a diagram of a structure of a data processing apparatus 2300 according to an embodiment of this application;

FIG. 24 is a diagram of a structure of another data processing apparatus 240 according to an embodiment of this application; and

FIG. 25 is a diagram of a structure of another data processing apparatus 250 according to an embodiment of this application.

## DESCRIPTION OF EMBODIMENTS

In the specification, claims, and accompanying drawings of this application, terms "first", "second", and the like are merely intended to distinguish between different objects but do not indicate a particular order. It can be understood that various numbers in embodiments of this application are merely used for differentiation for ease of description, but are not intended to limit the scope of embodiments of this application. Sequence numbers of the foregoing processes do not mean execution sequences. The execution sequences of the processes should be determined based on functions and internal logic of the processes. In addition, terms "include", "have", and any other variations thereof are intended to cover a non-exclusive inclusion. For example, processes, methods, systems, products, devices, or the like that include a series of steps or units are not limited to the listed steps or units, but optionally further include unlisted steps, units, or the like, or optionally further include other steps or units inherent to these processes, methods, products, devices, or the like.

"Embodiments" mentioned in this specification mean that particular features, structures, or characteristics described with reference to embodiments may be included in at least one embodiment of this application. The phrase shown at various locations in this specification does not necessarily refer to a same embodiment, and is not an independent or optional embodiment exclusive from other embodiments. A person skilled in the art can explicitly and implicitly understand that embodiments described in this specification may be combined with other embodiments.

Terms used in the following embodiments of this application are merely intended to describe specific embodiments, but are not intended to limit this application. Terms "a", "an", "the", "the foregoing", "this", and "such a" of singular forms used in this specification and the appended claims of this application are also intended to include plural forms, unless otherwise specified in the context clearly. It should also be understood that, a term "and/or" used in this application indicates and includes any or all possible combinations of one or more listed items. For example, "A and/or B" may represent three cases: Only A exists, only B exists, and both A and B exist. A and B each may be in a singular or plural form. A term "a plurality of" used in this application means two or more. In text descriptions of this application, a character "/" generally represents an "or" relationship between associated objects. A term "at least one" used in this application means one or more.

It can be understood that in embodiments of this application, "B corresponding to A" indicates that there is a correspondence between A and B, and B may be determined based on A. However, it should also be understood that determining (or generating) B based on (or according to) A does not mean that B is determined (or generated) only based on (or according to) A, and B may be determined (or generated) based on (or according to) A and/or other information.

For ease of understanding solutions of this application, the following first describes terms in embodiments of this application.

Native air-interface data that satisfies a dynamic spatial aggregation feature

The dynamic spatial aggregation feature means that data inherently exhibits a spatial clustering feature, but an aggregation location changes dynamically and continuously. The dynamic spatial aggregation feature holds true for a large amount of native air-interface data, such as ray tracing (ray tracing) data, and locations and speeds of a plurality of sensed targets. The following uses ray tracing data as an example for description. Methods in this application can also applied to other data having a similar feature, but details are not described again.

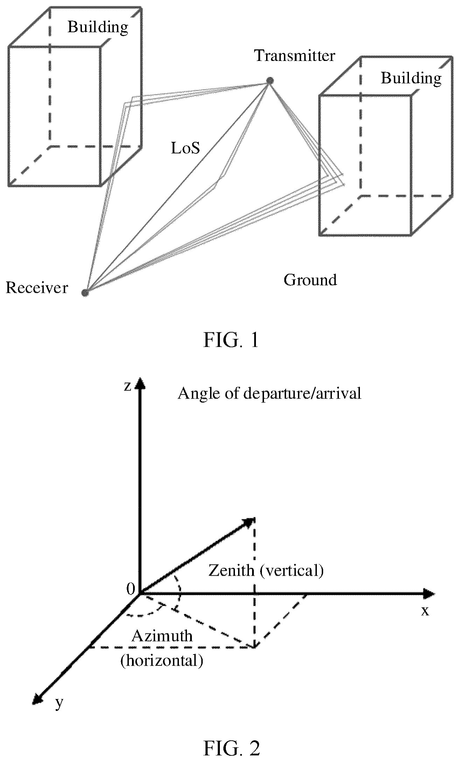

The ray tracing data mainly includes data of a plurality of ray paths. Each path includes parameters such as a delay, a path loss, angles of departure (classified into a horizontal angle of departure and a vertical angle of departure), and angles of arrival (classified into a horizontal angle of arrival and a vertical angle of arrival). A principle diagram of each path in ray tracing is shown in FIG. 1. FIG. 1 is the principle diagram of each path in ray tracing according to an embodiment of this application. In FIG. 1, two cuboids represent buildings (buildings), a plurality of ray paths exist between a transmitter (transmitter) and a receiver (receiver), where a LoS (line of sight) represents a direct path between the transmitter and the receiver, and ground represents the ground. FIG. 2 is a diagram of definitions of horizontal angles and vertical angles of an angle of departure (angle of departure, AoD)/an angle of arrival (angle of arrival, AoA) according to an embodiment of this application. As shown in FIG. 2, an azimuth (azimuth) is a horizontal angle (horizontal), the horizontal angle is an included angle (zenith) between a y-axis and a projection of a connection line between an origin and a current point on a horizontal plane (that is, a plane formed by an x-axis and the y-axis), and a vertical angle (vertical) is an included angle between the horizontal plane and the connection line between the origin and the current point.

The ray tracing data may be compactly represented in a form of a high-dimensional vector group $\{x_1, x_2, \ldots, x_N\}$, where each $x_i$ is a multi-dimensional vector (corresponding to an angle, a path loss, a delay, or the like in the ray tracing data), and $N$ is a quantity of to-be-transmitted data points (that is, a quantity of paths in ray tracing). Actually, a large amount of other native air-interface data may also be written in such a form. For example, for multi-target positioning data, $N$ is a quantity of positioned targets, and each $x_i$ corresponds to location coordinates of an $i^{th}$ target. The ray tracing data and the multi-target positioning data are both generated by an air interface (air interface) of a cellular system, and are not data generated by an upper-layer application. In addition, main functions of the ray tracing data and the multi-target positioning data are to assist in air-interface communication performance, and therefore the ray tracing data and the multi-target positioning data are referred to as native air-interface data. At present, channel state information (channel state information, CSI) data is native air-interface data widely known in a 5G system.

The ray tracing data usually plays a crucial role in estimating large-scale channel fading, assisting in network optimization, and the like. A sensing capability of a future communication system and environment modeling precision will be greatly improved. The ray tracing data can be used to accurately estimate some main-path information. The ray tracing data is directly used for communication assistance (such as beam management assistance and channel estimation assistance), including but not limited to the following scenarios:

A terminal device feeds back some main-path data in ray tracing to assist a base station in downlink precoding and beam management.

The base station uses the ray tracing data to assist in downlink precoding (without compression requirements).

The terminal device feeds back some main-path data in ray tracing to assist the base station in downlink precoding.

The base station delivers some main-path data in ray tracing to assist the terminal device in downlink reception or uplink transmission.

In a sidelink (side-link or side link) scenario, the base station obtains some inter-device main-path data based on location information of the terminal device, and delivers the data to assist in inter-device communication.

In the foregoing scenarios, a transmitter (which may be referred to as a transmit end) sends several pieces of main-path information (such as a delay/a path loss/an angle of arrival) obtained through ray tracing to a receiver (which may be referred to as a receive end). Compression and transmission of the ray tracing data need to meet a specific precision requirement based on a specific application scenario.

For example, for delay (delay) data, an error between a delay of each path that is restored through decompression at the receiver and a delay of original data needs to be strictly less than a specific upper limit $\varepsilon$. $\varepsilon$ depends on a bandwidth (time resolution) of the receiver and an application scenario.

Compression precision requirements for angle data and path loss data are similar.

Apparently, these requirements are also applicable to compression feedback of other native air-interface data. Herein, only the ray tracing data is used as an example for description.

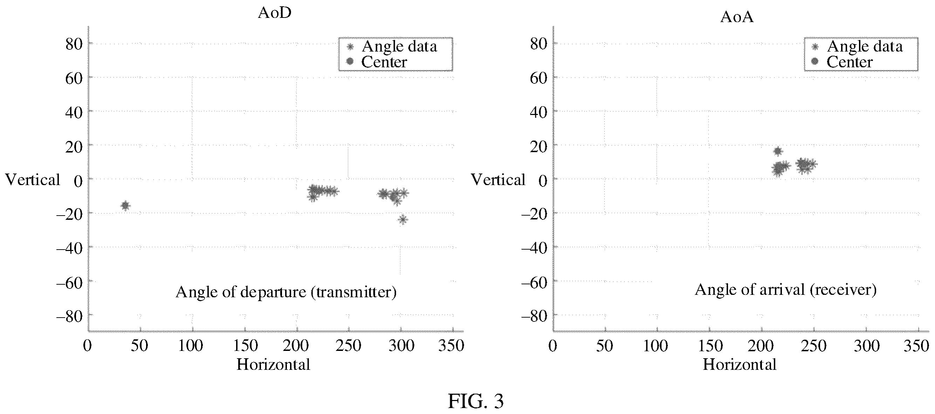

A plurality of paths in ray tracing are clustered in space, and the ray tracing data contains significant statistical redundancy. FIG. 3 shows this clustering feature by using an angle of departure and an angle of arrival as examples. FIG. 3 shows an example of angle data in ray tracing (only 10 paths with highest power are shown). As shown in FIG. 3, snowflake-shaped markers represent angles of departure (angles of departure)/angles of arrival (angles of arrival), circles represent cluster centers, angles of departure of ray paths are clustered in space, and angles of arrival of the ray paths are clustered in space.

The following first describes communication systems to which a data compression scheme and a data decompression scheme provided in this application are applicable.

The data compression scheme and the data decompression scheme provided in this application can be applied to a long term evolution (long term evolution, LTE) system, an LTE frequency division duplex (frequency division duplex, FDD) system, an LTE time division duplex (time division duplex, TDD) system, a universal mobile telecommunications system (universal mobile telecommunications system, UMTS), a worldwide interoperability for microwave access (worldwide interoperability for microwave access, WiMAX) communication system, a 5th generation (5th generation, 5G) communication system, a future 6th generation (6th generation, 6G) communication system, and the like. Certainly, encoding and decoding schemes provided in this application can also be applied to other possible communication systems, for example, an internet of things (internet of things, IoT) network and a wireless local area network system supporting 802.11 series protocols, a wireless personal area network system based on an ultra-wideband UWB, a sensing (sensing) system, an internet of vehicles (vehicle to X, V2X), machine type communication (machine type communication, MTC), machine-to-machine information exchange (long term evolution-machine, LTE-M), machine to machine (machine to machine, M2M), vehicle to vehicle (vehicle to vehicle, V2V), vehicle-to-vehicle information exchange (long term evolution-vehicle, LTE-V), a satellite communication system, and future wireless communication systems with sensing functions, such as a next generation cellular system and a short-range wireless communication system. The communication systems to which this application is applicable are merely examples for description, and are not limited thereto. Unified descriptions are provided herein, and are not described below again.

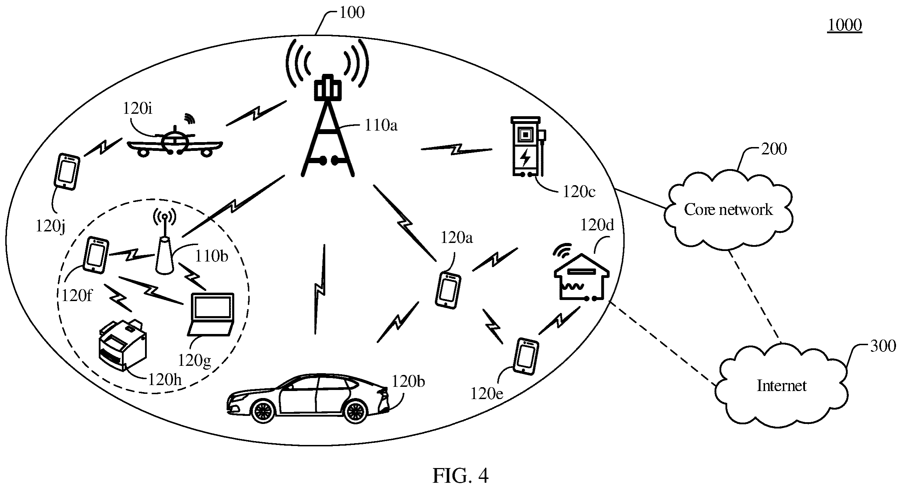

FIG. 4 is a diagram of an architecture of a communication system 1000 to which an embodiment of this application is applied. As shown in FIG. 4, the communication system includes a radio access network 100 and a core network 200. Optionally, the communication system 1000 may further include an internet 300. The radio access network 100 may include at least one radio access network device (for example, 110a and 110b in FIG. 4), and may further include at least one terminal (for example, 120a to 120j in FIG. 4). The terminal (terminal device) is connected to the radio access network device in a wireless manner, and the radio access network device is connected to the core network in a wireless or wired manner. A core network device and the radio access network device may be different independent physical devices, functions of the core network device and logical functions of the radio access network device may be integrated into one physical device, or some functions of the core network device and some functions of the radio access network device may be integrated into one physical device. A wired or wireless manner may be used for connections between terminals and between radio access network devices. FIG. 4 is merely a diagram. The communication system may further include other network devices, for example, may further include a wireless relay device and a wireless backhaul device, which are not shown in FIG. 4.

The radio access network device is an access device used by the terminal to access the communication system in a wireless manner. The radio access network device may be a base station (base station), an evolved NodeB (evolved NodeB, eNodeB), a transmission reception point (transmission reception point, TRP), a next generation NodeB (next generation NodeB, gNB) in a 5th generation (5th generation, 5G) mobile communication system, a next generation base station in a 6th generation (6th generation, 6G) mobile communication system, a base station in a future mobile communication system, an access node in a Wi-Fi system, or the like; or may be a module or unit that completes some functions of a base station, for example, may be a central unit (central unit, CU) or a distributed unit (distributed unit, DU). The CU herein completes functions of a radio resource control protocol and a packet data convergence protocol (packet data convergence protocol, PDCP) of the base station, and may further complete functions of a service data adaptation protocol (service data adaptation protocol, SDAP). The DU completes functions of a radio link control layer and a medium access control (medium access control, MAC) layer of the base station, and may further complete some or all functions of a physical layer. For specific descriptions of the foregoing protocol layers, refer to related technical specifications of the 3rd generation partnership project (3rd generation partnership project, 3GPP). The radio access network device may be a macro base station (for example, 110a in FIG. 4), may be a micro base station or an indoor base station (for example, 110b in FIG. 4), or may be a relay node, a donor node, or the like. A specific technology and a specific device form that are used by the radio access network device are not limited in embodiments of this application. For ease of description, the following provides descriptions by using an example in which the radio access network device is a base station.

The terminal is a device having wireless receiving and sending functions, and may send a signal to the base station or receive a signal from the base station. The terminal may also be referred to as a terminal device, user equipment (user equipment, UE), a mobile station, a mobile terminal, or the like. The terminal can be widely used in various scenarios, for example, device-to-device (device-to-device, D2D), vehicle-to-everything (vehicle-to-everything, V2X) communication, machine type communication (machine type communication, MTC), an internet of things (internet of things, IoT), virtual reality, augmented reality, industrial control, self-driving, telemedicine, a smart grid, smart furniture, a smart office, smart wearable, smart transportation, and a smart city. The terminal may be a mobile phone, a tablet computer, a computer having wireless receiving and sending functions, a wearable device, a vehicle, an airplane, a ship, a robot, a robotic arm, a smart household device, or the like. A specific technology and a specific device form that are used by the terminal are not limited in embodiments of this application.

The base station and the terminal may be at invariable locations, or may be movable. The base station and the terminal may be deployed on land, including an indoor device, an outdoor device, a handheld device, or a vehicle-mounted device; may be deployed on water; or may be deployed on an airplane, a balloon, or an artificial satellite. Application scenarios of the base station and the terminal are not limited in embodiments of this application.

Roles of the base station and the terminal may be relative. For example, a helicopter or an uncrewed aerial vehicle 120i in FIG. 4 may be configured as a mobile base station. For the terminal 120j accessing the radio access network 100 through 120i, the terminal 120i is a base station. However, for the base station 110a, 120i is a terminal. In other words, communication between 110a and 120i is performed based on a radio air interface protocol. Certainly, communication between 110a and 120i may be alternatively performed based on an interface protocol between base stations. In this case, for 110a, 120i is also a base station. Therefore, both the base station and the terminal may be collectively referred to as communication apparatuses, 110a and 110b each in FIG. 4 may be referred to as a communication apparatus having a base station function, and 120a to 120j each in FIG. 4 may be referred to as a communication apparatus having a terminal function.

Communication between a base station and a terminal, between base stations, or between terminals may be performed by using a licensed spectrum, may be performed by using an unlicensed spectrum, or may be performed by using both a licensed spectrum and an unlicensed spectrum. Communication may be performed by using a spectrum below 6 gigahertz (gigahertz, GHz), may be performed by using a spectrum above 6 GHz, or may be performed by using both a spectrum below 6 GHz and a spectrum above 6 GHz. Spectrum resources used for wireless communication are not limited in embodiments of this application.

In this embodiment of this application, a function of the base station may be alternatively performed by a module (for example, a chip) in the base station, or may be performed by a control subsystem including the function of the base station. The control subsystem including the function of the base station herein may be a control center in the foregoing application scenarios, such as a smart grid, industrial control, smart transportation, and a smart city. A function of the terminal may be alternatively performed by a module (for example, a chip or a modem) in the terminal, or may be performed by an apparatus including the function of the terminal.

In this application, the base station sends a downlink signal or downlink information to the terminal, where the downlink information is carried on a downlink channel; and the terminal sends an uplink signal or uplink information to the base station, where the uplink information is carried on an uplink channel. To communicate with the base station, the terminal needs to establish a wireless connection to a cell controlled by the base station. The cell that establishes the wireless connection to the terminal is referred to as a serving cell of the terminal. When communicating with the serving cell, the terminal is further interfered with by a signal from a neighboring cell.

As described in the background part, compression technologies with desirable compression performance for multi-dimensional data need to be researched at present. This application mainly proposes an efficient compression scheme for multi-dimensional native air-interface data having a dynamic clustering feature, so that precision of decompressed data in one or more dimensions and original data can be strictly less than a specific threshold. In contrast, existing multi-dimensional data compression methods cannot meet the requirement. The following describes, with reference to the accompanying drawings, the data compression scheme and the data decompression scheme provided in this application.

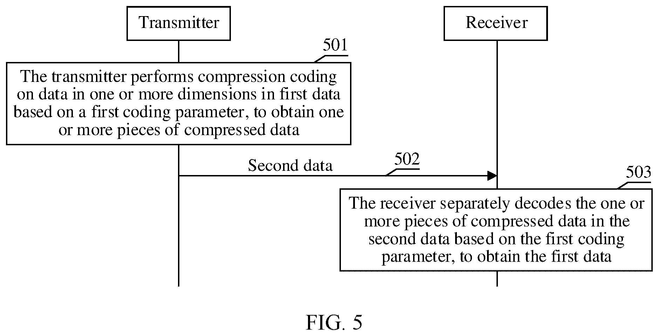

FIG. 5 is a flowchart of a data compression transmission interaction method according to an embodiment of this application. As shown in FIG. 5, the method includes the following steps.

501: A transmitter performs compression coding on data in one or more dimensions in first data based on a first coding parameter, to obtain one or more pieces of compressed data.

The transmitter may be a terminal, or may be a network device, for example, a base station. For example, one or more elements in the first data are one-dimensional data, and the first coding parameter includes a coding parameter in one dimension. The transmitter performs compression coding (for example, entropy coding) on the one or more elements in this dimension in the first data by using the coding parameter in this dimension, to obtain second data. For another example, one or more elements in the first data are two-dimensional data, and the first coding parameter includes a coding parameter in a first dimension and a coding parameter in a second dimension. The transmitter performs compression coding on data in the first dimension in the one or more elements by using the coding parameter in the first dimension, and performs compression coding on data in the second dimension in the one or more elements by using the coding parameter in the second dimension, to obtain second data. One or more elements in the first data may be three-dimensional, four-dimensional, or higher-dimensional. It should be understood that the transmitter may perform, by using a coding parameter in each dimension in the first coding parameter, compression coding on data in the corresponding dimension in the one or more elements in the first data in a similar manner. It should be noted that, that the transmitter performs compression coding on the data in the one or more dimensions in the first data based on the first coding parameter may be: The transmitter performs compression coding on some or all data in the first data based on the first coding parameter. In other words, the transmitter may perform compression coding on all the elements in the first data, or may perform compression coding on only some elements in the first data.

The first coding parameter may satisfy a target condition, and the target condition is that a code length obtained by performing compression coding on the data in the one or more dimensions in the first data based on the first coding parameter is a shortest one in a plurality of code lengths. The plurality of code lengths include code lengths obtained by performing compression coding on the data in the one or more dimensions in the first data separately based on a plurality of groups of coding parameters, and the plurality of groups of coding parameters include the first coding parameter. In some possible embodiments, before performing step 501, the transmitter obtains the plurality of code lengths obtained by performing compression coding on the data in the one or more dimensions in the first data based on the plurality of groups of coding parameters; and then determines a coding parameter corresponding to the shortest one in the plurality of code lengths, namely, the first coding parameter. Alternatively, the first coding parameter may be a group of coding parameters that are obtained in another manner and that are used to perform compression coding on the data in the one or more dimensions in the first data to obtain a relatively short code length.

In a possible implementation, before performing step 501, the transmitter obtains the plurality of code lengths obtained by performing compression coding on the data in the one or more dimensions in the first data separately based on the plurality of groups of coding parameters, where the plurality of groups of coding parameters are in one-to-one correspondence with the plurality of code lengths; and determine that the code length obtained by performing compression coding on the data in the one or more dimensions in the first data based on the first coding parameter is the shortest one in the plurality of code lengths. In this implementation, it is determined that the code length obtained by performing compression coding on the data in the one or more dimensions in the first data based on the first coding parameter is the shortest one in the plurality of code lengths, to obtain an optimal coding parameter.

502: The transmitter sends the second data to a receiver.

Correspondingly, the receiver receives the second data from the transmitter. The transmitter may be a terminal, or may be a network device. For example, the transmitter is any terminal in the communication system shown in FIG. 4, and the receiver is a radio access network device in the communication system shown in FIG. 4. For another example, the transmitter is a radio access network device in the communication system shown in FIG. 4, and the receiver is any terminal in the communication system shown in FIG. 4. For still another example, the transmitter and the receiver are any two terminals that can directly communicate with each other (for example, through a PC5 interface) in the communication system shown in FIG. 4. The second data includes the one or more pieces of compressed data and first indication information. The first indication information indicates the first coding parameter.

In a possible implementation, the one or more pieces of compressed data include t pieces of sequentially arranged data in a fifth dimension, the second data further includes a second quantized value, the second quantized value is obtained by quantizing minimum or maximum data in the fifth dimension in the first data, the t pieces of sequentially arranged data in the fifth dimension are obtained based on a difference obtained by performing differencing on sequentially arranged data in the fifth dimension in the first data, and t is an integer greater than or equal to 2. In this implementation, differencing is performed on the t pieces of sequentially arranged data in the fifth dimension, and then the obtained difference is quantized. This can improve compression performance.

In a possible implementation, the second data further includes fifth indication information, and the fifth indication information indicates t.

In a possible implementation, the one or more pieces of compressed data further include t pieces of sequentially arranged data in a sixth dimension, the t pieces of sequentially arranged data in the sixth dimension are obtained based on a plurality of differences obtained by performing periodic differencing on data in the sixth dimension in the first data, the second data further includes a third quantized value, and the third quantized value is obtained by quantizing one of two pieces of data that are in the data in the sixth dimension and that yield a maximum difference through differencing. In this implementation, differencing is performed on the t pieces of sequentially arranged data in the sixth dimension, and then the obtained difference is quantized. This can improve compression performance.

In a possible implementation, the second data further includes sixth indication information, and the sixth indication information indicates a correspondence between the t pieces of data in the fifth dimension and the t pieces of data in the sixth dimension. In this implementation, the sixth indication information indicates the correspondence between the t pieces of data in the fifth dimension and the t pieces of data in the sixth dimension, so that the receiver combines the t pieces of data in the fifth dimension and the t pieces of data in the sixth dimension into t pieces of two-dimensional data based on the correspondence.

503: The receiver separately decodes the one or more pieces of compressed data in the second data based on the first coding parameter, to obtain the first data.

The transmitter may be a terminal, or may be a network device, for example, a base station. For example, the transmitter is a terminal, and the receiver is a network device. For another example, the transmitter is a network device, and the receiver is a terminal. Before performing step 503, the receiver may determine the coding parameter in each dimension in the first coding parameter based on the first indication information in the second data. For example, the one or more pieces of compressed data in the second data are one-dimensional data, and the first coding parameter includes a coding parameter in one dimension. The receiver decodes the one or more pieces of compressed data in this dimension in the second data by using the coding parameter in this dimension, to obtain the first data. For another example, the one or more pieces of compressed data in the second data are two-dimensional data (or elements), and the first coding parameter includes a coding parameter in a first dimension and a coding parameter in a second dimension. The receiver decodes data in the first dimension in the one or more pieces of compressed data by using the coding parameter in the first dimension, and decodes data in the second dimension in the one or more pieces of compressed data by using the coding parameter in the second dimension, to obtain the first data. Alternatively, the one or more pieces of compressed data in the second data may be three-dimensional, four-dimensional, or higher-dimensional data. It should be understood that the receiver may decode, by using the coding parameter in each dimension in the first coding parameter, data in the corresponding dimension in the one or more pieces of compressed data in the second data in a similar manner. It should be noted that, that the receiver decodes, by using the coding parameter in each dimension in the first coding parameter, entropy-coded data in the corresponding dimension in the second data may be: The receiver decodes, by using the coding parameter in each dimension in the first coding parameter, some or all data in the corresponding dimension in the second data.

In this embodiment of this application, the transmitter performs compression coding on the data in the one or more dimensions in the first data based on the first coding parameter. Because the code length obtained by performing compression coding on the data in the one or more dimensions in the first data based on the first coding parameter is the shortest one in the plurality of code lengths, compression performance can be improved by performing compression coding on the data in the one or more dimensions in the first data based on the first coding parameter, that is, the shortest code length can be obtained. In addition, the second data sent by the transmitter to the receiver includes the first indication information indicating the coding parameter in each dimension in the first coding parameter, so that the coding parameter can be dynamically indicated.

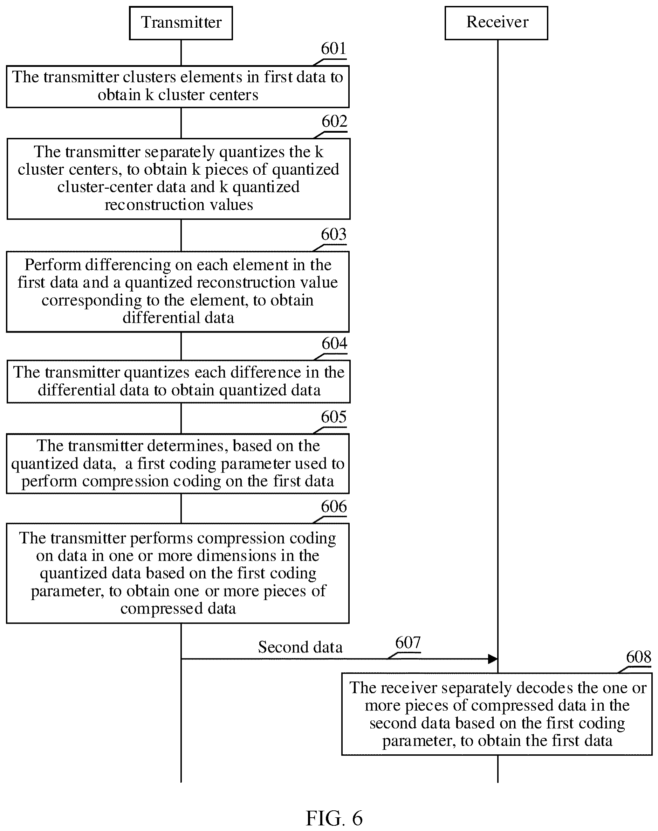

FIG. 6 is a flowchart of another data compression transmission interaction method according to an embodiment of this application. A method procedure in FIG. 6 is a possible implementation of the method described in FIG. 5. In this implementation, a transmitter compresses data by using a clustering+entropy coding scheme, and compression performance can be improved by fully utilizing a dynamic aggregation feature of the data. As shown in FIG. 6, the method includes the following steps.

601: The transmitter clusters elements in first data to obtain k cluster centers.

The first data may be native air-interface data that satisfies a dynamic spatial aggregation feature, such as ray tracing data, and locations and speeds of a plurality of sensed targets. The elements in the first data may be one-dimensional data, two-dimensional data, or multi-dimensional data. This is not limited in this application. For example, the transmitter clusters the elements in the first data by using a k-means (k-means) clustering algorithm. A clustering parameter k used by the transmitter, namely, a quantity of cluster centers, may be preconfigured by the transmitter and a receiver, or a clustering parameter k with optimal compression performance may be dynamically indicated by the transmitter during each transmission. k is an integer greater than 0. The transmitter may alternatively cluster the elements in the first data in another manner. This is not limited in this application. The following describes, by using compression of four pieces of angle data in ray tracing as an example, details of the solutions provided in this application. The transmitter and the receiver may represent angles of each ray path as a four-dimensional vector (a horizontal angle of departure, a vertical angle of departure, a horizontal angle of arrival, and a vertical angle of arrival). An order of the four angles is agreed by the transmitter and the receiver. If only angle-of-arrival data is compressed, a two-dimensional vector formed by two angles of arrival is considered. The solutions provided in this application are not limited to two cases in which dimensions are equal to two or four.

602: The transmitter separately quantizes the k cluster centers, to obtain k pieces of quantized cluster-center data and k quantized reconstruction values.

The transmitter and the receiver may preconfigure quantization precision used to quantize the cluster center. In other words, the transmitter and the receiver may preconfigure quantization precision of cluster-center data. The transmitter may separately quantize the k cluster centers based on the configured quantization precision, to obtain the k pieces of quantized cluster-center data and the k quantized reconstruction values. The k pieces of quantized cluster-center data are in one-to-one correspondence with the k cluster centers. For example, the k cluster centers include a cluster center 1, a cluster center 2, ..., and a cluster center k, and the k pieces of quantized cluster-center data include quantized cluster-center data 1, quantized cluster-center data 2, ..., and quantized cluster-center data k. The quantized cluster-center data 1 is obtained by quantizing the cluster center 1, the quantized cluster-center data 2 is obtained by quantizing the cluster center 2, ..., and the quantized cluster-center data k is obtained by quantizing the cluster center k. The k quantized reconstruction values (or referred to as reconstruction points) are in one-to-one correspondence with the k pieces of quantized cluster-center data. Each piece of quantized cluster-center data is one or more bit strings, and each bit string corresponds to one dimension. Each quantized reconstruction value is a value represented by quantized cluster-center data corresponding to the quantized reconstruction value. For example, the quantized cluster-center data 1 is (110111, 01111110), a quantized reconstruction value corresponding to the quantized cluster-center data 1 is (a value A, a value B), the value A is a value represented by 110111, and the value B is a value represented by 01111110. Each element in the first data corresponds to one cluster center and one quantized reconstruction value. For example, an element in the first data belongs to a cluster (group) corresponding to the cluster center 1, the element corresponds to the cluster center 1, and the element corresponds to a quantized reconstruction value corresponding to the quantized cluster-center data 1 obtained by quantizing the cluster center 1.

603: The transmitter performs differencing on each element in the first data and a quantized reconstruction value corresponding to the element, to obtain differential data.

For example, an element 1 in the first data corresponds to a quantized reconstruction value 1, and an element 2 in the first data corresponds to a quantized reconstruction value 2. That the transmitter performs differencing on each element in the first data and the quantized reconstruction value corresponding to the element includes: The transmitter performs differencing on the element 1 and the quantized reconstruction value 1 to obtain a difference 1, and performs differencing on the element 2 and the quantized reconstruction value 2 to obtain a difference 2. First differential data includes the difference 1 and the difference 2.

604: The transmitter quantizes each difference in the differential data to obtain quantized data.

The quantized data includes a quantized value obtained by quantizing each difference in the differential data. For example, the transmitter performs uniform scalar quantization on each difference in the differential data based on preconfigured quantization precision, to obtain the quantized data. A quantization precision requirement of data in each dimension is preconfigured by the transmitter and the receiver. When the difference is two-dimensional or multi-dimensional data, the transmitter separately quantizes data in different dimensions in the difference, and quantization precision requirements of the data in the different dimensions in the difference are identical or different.

605: The transmitter determines, based on the quantized data, a first coding parameter used to perform compression coding on the first data.

A possible implementation of step 605 is as follows: The transmitter calculates a plurality of code lengths obtained by performing compression coding on data in one or more dimensions in the quantized data based on a plurality of groups of coding parameters, where each code length corresponds to one group of coding parameters. When a code length obtained by performing compression coding on the data in the one or more dimensions in the quantized data based on the first coding parameter is a shortest one in the plurality of code lengths, the transmitter determines to perform compression coding on the first data by using the first coding parameter. For example, the transmitter separately calculates a code length obtained by performing compression coding on the data in the one or more dimensions in the quantized data by using each group of coding parameters in a candidate parameter set. When the code length obtained by performing compression coding on the quantized data by using the first coding parameter is the shortest, the transmitter determines to perform entropy coding on the first data by using the first coding parameter. For another example, the transmitter separately calculates a code length obtained by performing compression coding on the data in the one or more dimensions in the quantized data based on each group of coding parameters in a candidate parameter set. When the code length obtained by performing compression coding on the quantized data based on the first coding parameter is less than a code length threshold, the transmitter determines to perform compression coding on the first data by using the first coding parameter, and stops calculating a code length obtained by performing compression coding on the quantized data by using other groups of coding parameters. In this example, before calculating the code length obtained by performing compression coding on the quantized data by using the first coding parameter, the transmitter uses the coding parameters in the candidate parameter set to calculate the code lengths that are all less than the code length threshold. The code length threshold may be configured depending on an actual requirement, and is not limited herein. The transmitter may alternatively determine, in another manner, the first coding parameter used to perform compression coding on the first data. This is not limited herein.

An example of calculating, by the transmitter, a code length obtained by performing compression coding on the data in the one or more dimensions in the quantized data based on one group of coding parameters is as follows: mapping each quantized value in the quantized data to a nonnegative integer to obtain to-be-encoded data; and calculating a code length obtained by performing Golomb coding on each nonnegative integer in the to-be-encoded data based on one group of coding parameters. A possible manner in which the transmitter converts a quantized value into a nonnegative integer is: obtaining an absolute value of the quantized value. In this manner, sign bits of all elements also need to be retained and sent to the receiver. A possible manner in which the transmitter converts a quantized value into a nonnegative integer is: first determining a value range [ymin, ymax] (where ymin is negative and ymax is positive) of quantized value (denoted as t), denoting a smaller absolute value of ymin and ymax as T=min{|ymin|, |ymax|}, and then t is converted into a nonnegative integer by using the following conversion f(t):

$$\text{f(t)} = \begin{cases} 2t, & 0 \le t \le T \\ 2|t| - 1, & -T \le t < 0 \\ t + T, & otherwise \end{cases} \quad (1),$$

where
f(t) represents a nonnegative integer obtained by mapping the quantized value t.

First, specific compression details of Golomb coding are provided. Assuming that a Golomb code parameter is m and a to-be-compressed nonnegative integer is n, main compression steps are as follows:

(1) Calculate a quotient $q = \left\lfloor \dfrac{n}{m} \right\rfloor$ and a remainder $r = n - qm$ ($0 \le r \le m$ - 1) obtained by dividing n by m.

(2) Compress the quotient $q$ by using a unary code (unary code), so that $q$ is represented as 11...10 (where a quantity of digits 1 is q).

(3) Compress the remainder $r$ into a binary representation of $\lceil log_2 \, m \rceil$ bits.

The unary code of the nonnegative integer q is defined as (q-1) digits 1 followed by one digit 0. Golomb coding satisfies the following characteristics: Assuming that the Golomb code parameter is m and the to-be-compressed nonnegative integer is n, a length of an output codeword obtained by compressing n through Golomb coding may be represented as a function of m and n:

$$f(n,m) = \left\lfloor \frac{n}{m} \right\rfloor + 1 + \lceil log_2 \, m \rceil \quad (2)$$

$f(n, m)$ represents the length of the output codeword obtained by compressing n through Golomb coding, $\left\lfloor \dfrac{n}{m} \right\rfloor$ represents rounding down ($\dfrac{n}{m}$), and $\lceil log_2 \, m \rceil$ represents rounding up ($log_2 \, m$). It can be learned from the formula (2) that, the transmitter can directly calculate the length of the output codeword obtained by compressing n, without performing a compression operation on n. In the formula (2), $\left\lfloor \dfrac{n}{m} \right\rfloor + 1$ is a length obtained through compression on the quotient q by using the unary code, and $\lceil log_2 \, m \rceil$ is a length obtained through representation of the remainder r by using a binary code. The formula (2) shows the length of the output codeword obtained by compressing n through Golomb coding. It should be understood that the transmitter may calculate, in a similar manner, a length of an output codeword obtained by performing Golomb coding on each nonnegative integer in the to-be-encoded data, to obtain a code length obtained by performing Golomb coding on each nonnegative integer in the to-be-encoded data.

606: The transmitter performs compression coding on the data in the one or more dimensions in the quantized data based on the first coding parameter, to obtain one or more pieces of compressed data.

For step 606, refer to step 501. Second data may include the one or more pieces of compressed data, first indication information, and the k pieces of quantized cluster-center data, and one piece of quantized cluster-center data corresponds to the one or more pieces of compressed data in the second data. k is an integer greater than or equal to 1. For example, the k pieces of quantized cluster-center data are k bit strings with a fixed length, and each bit string represents one quantized reconstruction value and corresponds to one cluster center. Each of the one or more pieces of compressed data may be corresponding to one of the k pieces of quantized cluster-center data. Optionally, the one or more pieces of compressed data are divided into k groups, and each group corresponds to one piece of quantized cluster-center data. In other words, the k groups of compressed data are in one-to-one correspondence with the k pieces of quantized cluster-center data.

In a possible implementation, the second data further includes second indication information, and the second indication information identifies a correspondence between the k pieces of quantized cluster-center data and the one or more pieces of compressed data. In this implementation, the receiver can learn the correspondence between the k pieces of quantized cluster-center data and the one or more pieces of compressed data.

In a possible implementation, the second data further includes third indication information, and the third indication information indicates k. In this implementation, the receiver can learn a quantity of quantized cluster-center data.

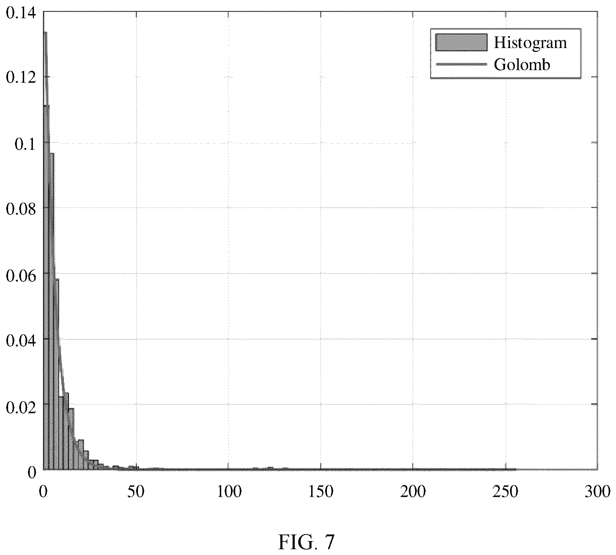

In some possible embodiments, step 605 and step 606 are replaced with the following: The transmitter separately performs, based on a coding parameter in each dimension in the first coding parameter, entropy coding on data in a corresponding dimension in one or more elements in the quantized data, to construct a respective Huffman codebook. In other words, entropy coding is separately performed on data in different dimensions in the one or more elements in the quantized data, that is, different coding parameters are used for the data in the different dimensions. Alternatively, a coding parameter and a codebook may be reused for data in different dimensions. In some possible embodiments, Monte Carlo (Monte Carlo) simulation (this process is performed offline) is used to collect statistics on a probability distribution of nonnegative integers sent by the transmitter. The probability distribution can be well approximated by a geometric distribution with a parameter p. FIG. 7 shows an example of approximation of an actual data distribution using a geometric distribution with a parameter p. In FIG. 7, each column represents a probability distribution of a nonnegative integer, and a curve represents the geometric distribution with the parameter p.

To further reduce parameter indication overheads (overheads), the parameter p may be restricted to $p = 2^{-\frac{1}{m}}$ (where m is a positive integer), and a parameter m is optimized. An actual probability model is as follows:

$$P(X = n) = p^{n-1}q, q = 1 - p, p = 2^{-\frac{1}{m}} \quad (3)$$

n represents the to-be-compressed nonnegative integer. Actually, the candidate parameter set $\mathcal{M}$ may be preconfigured, and the optimal parameter m, that is, a parameter in one dimension in the first coding parameter, is selected from the candidate parameter set $\mathcal{M}$. A subscript of the selected parameter m may be indicated by using $\lceil log_2(|M|) \rceil$ bits. For example, a parameter m that minimizes a distance between the probability distribution shown in the formula (3) and a probability distribution obtained through statistics collection may be selected, and the distance measure may be a KL divergence (KL divergence) or a total variation distance (total variation distance). The first coding parameter includes an optimal parameter in one or more dimensions selected from the candidate parameter set $\mathcal{M}$. It can be understood that the optimal parameter m may be optimized offline through MC simulation, and an optimal parameter m obtained through optimization is configured for the transmitter and the receiver. The transmitter and the receiver include a transmitter (which may be referred to as a transmit end) and a receiver (which may be referred to as a receive end). The transmitter and the receiver construct a same Huffman codebook based on the parameter m, and use the Huffman codebook for a long time after configuration. Alternatively, the transmitter or the receiver optimizes the parameter m based on historical data in a period of time, and if the parameter m changes, an update is triggered.

In some possible embodiments, step 605 and step 606 are replaced with: representing the data in the one or more dimensions in the quantized data as a bit string; and performing compression coding on the bit string in the quantized data by using Lempel-Ziv coding or adaptive arithmetic coding, to obtain the second data, where the second data does not include the first indication information.

607: The transmitter sends the second data to the receiver.

For step 607, refer to step 502.

In a possible implementation, the second data includes first coding information and second coding information, the first coding information includes data in a first dimension in the one or more pieces of compressed data, the second coding information includes data in a second dimension in the one or more pieces of compressed data, the data in the first dimension in the one or more pieces of compressed data is obtained by performing compression coding based on data in the first dimension in the first data and a coding parameter in the first dimension in the first coding parameter, and the data in the second dimension in the one or more pieces of compressed data is obtained by performing compression coding based on data in the second dimension in the first data and a coding parameter in the second dimension in the first coding parameter. The second data may further include third coding information and/or fourth coding information, where the third coding information includes data in a third dimension in the one or more pieces of compressed data, the fourth coding information includes data in a fourth dimension in the one or more pieces of compressed data, and the third dimension is different from the fourth dimension. When the compressed data in the second data is two-dimensional data, the second data includes the first coding information and the second coding information. When the compressed data in the second data is three-dimensional data, the second data includes the first coding information, the second coding information, and the third coding information. When the compressed data in the second data is four-dimensional data, the second data includes the first coding information, the second coding information, the third coding information, and the fourth coding information. The first coding information and the second coding information are merely an example of data in two dimensions in the second data. The second data may include the third coding information, the fourth coding information, and other coding information. This is not limited herein. In this implementation, the second data includes the first coding information and the second coding information. Because data in a same dimension in the one or more pieces of compressed data is located in same information, a data compression speed and a data decompression speed can be improved.

In a possible implementation, first compressed data in the one or more pieces of compressed data corresponds to first quantized cluster-center data in the k pieces of quantized cluster-center data, the first coding information includes data in the first dimension in the first compressed data, the data in the first dimension in the first compressed data is obtained by performing compression coding on a first quantized value by using the coding parameter in the first dimension in the first coding parameter, the first quantized value is obtained by quantizing a first difference, and the first difference is a difference between data that is in the first dimension in the first data and that corresponds to an element of the first quantized cluster-center data and data in the first dimension in the first quantized cluster-center data. This implementation provides a manner of obtaining one piece of data in the first coding information. It can be understood that the second coding information, the third coding information, and the like may be obtained in a similar manner. Details are not described herein again.

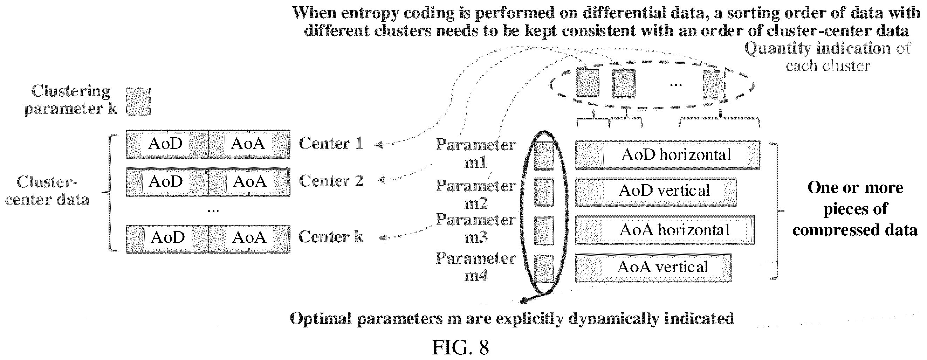

FIG. 8 shows an example of second data according to an embodiment of this application. The second data in FIG. 8 is obtained by performing compression coding on four-dimensional ray tracing data (that is, first data) that includes a horizontal angle of departure (AoD horizontal), a vertical angle of departure (AoD vertical), a horizontal angle of arrival (AoA horizontal), and a vertical angle of arrival (AoA vertical). As shown in FIG. 8, the second data includes a clustering parameter k (optional); quantized cluster-center data (a center 1, a center 2, ..., and a center k in FIG. 8 each represent one piece of quantized cluster-center data); four-dimensional coding parameters in a first coding parameter, namely, a parameter m1, a parameter m2, a parameter m3, and a parameter m4; one or more pieces of compressed data, where from top to bottom, a first row is AoD horizontal compressed data, a second row is AoD vertical compressed data, a third row is AoA horizontal compressed data, and a fourth row is AoA vertical compressed data; and a quantity indication of each cluster that identifies a correspondence between the k pieces of quantized cluster-center data and the one or more pieces of compressed data. The AoD horizontal compressed data is used as an example in FIG. 8. The AoD horizontal compressed data is arranged from left to right, a first piece of compressed data to an $s1^{th}$ piece of compressed data correspond to the center 1, an $(s1+1)^{th}$ piece of compressed data to an $s2^{th}$ piece of compressed data correspond to the center 2, an $(s2+1)^{th}$ piece of compressed data to an $s3^{th}$ piece of compressed data correspond to the center 3, and so on. s1, s2, and s3 are all integers greater than 0. It can be understood that the receiver may determine, based on the quantity indication of each cluster, quantized cluster-center data corresponding to each piece of compressed data. Compressed data in different dimensions shares the quantity indication of each cluster that identifies the correspondence between the k pieces of quantized cluster-center data and the one or more pieces of compressed data. The quantity indication of each cluster in the second data may dynamically indicate a quantity of vectors corresponding to each cluster in a clustering result. As shown in FIG. 8, optimal parameters, namely, the parameter m1, the parameter m2, the parameter m3, and the parameter m4, are explicitly dynamically indicated. When entropy coding is performed on differential data, a sorting order of data with different clusters needs to be kept consistent with an order of cluster-center data.

608: The receiver separately decodes the one or more pieces of compressed data in the second data based on the first coding parameter, to obtain the first data.

For step 608, refer to step 503. It should also be noted herein that, when compression coding is performed on differences, a sorting order of differential data of different cluster centers needs to be kept consistent with a sorting order of cluster-center data, to ensure correct decoding performed by the receiver. The receiver may first decode the clustering parameter k, decode the quantized cluster-center data (or the quantized reconstruction values), decode the differences, add the differences and the corresponding quantized reconstruction values (this step requires that the sorting order of the differential data needs to be kept consistent with the sorting order of the cluster-center data), and finally restore original data, that is, the first data.

In this embodiment of this application, data is compressed through clustering and differencing, so that a dynamic aggregation feature of the data can be effectively utilized for compression, and compression performance is desirable.

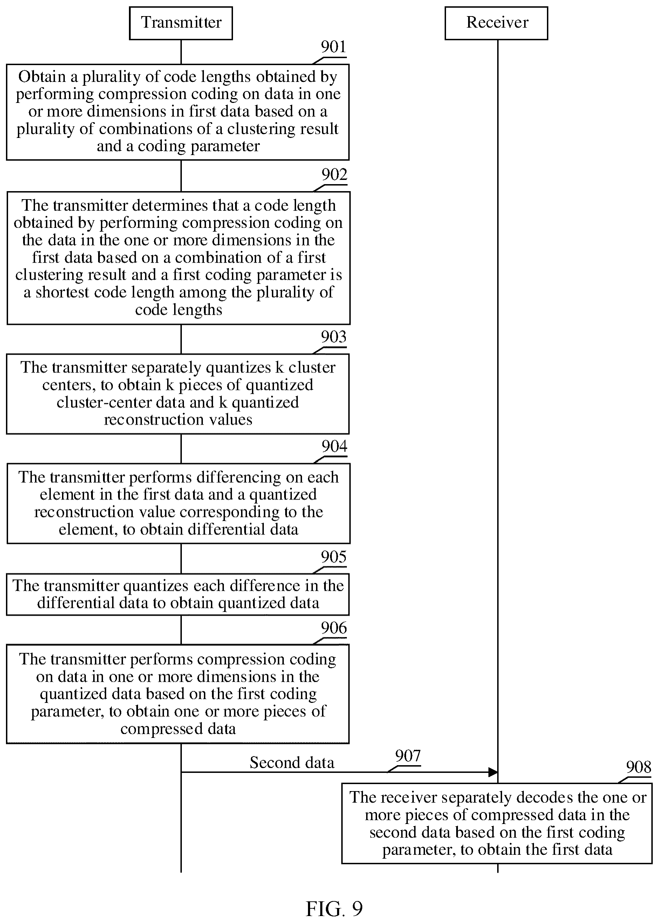

FIG. 9 is a flowchart of another data compression transmission interaction method according to an embodiment of this application. A method procedure in FIG. 9 is a possible implementation of the method described in FIG. 5. In this implementation, a transmitter compresses data in a clustering+entropy coding joint optimization manner, and compression performance can be improved by fully utilizing a dynamic aggregation feature of the data. As shown in FIG. 9, the method includes the following steps.

901: The transmitter obtains a plurality of code lengths obtained by performing compression coding on data in one or more dimensions in first data based on a plurality of combinations of a clustering result and a coding parameter.

The plurality of code lengths obtained by performing compression coding on the data in the one or more dimensions in the first data based on the plurality of combinations of the clustering result and the coding parameter may include: a code length #1 obtained by performing compression coding on the data in the one or more dimensions in the first data based on a combination of a clustering result 1 and a coding parameter 1, a code length #2 obtained by performing compression coding on the data in the one or more dimensions in the first data based on a combination of the clustering result 1 and a coding parameter 2, and a code length #3 obtained by performing compression coding on the data in the one or more dimensions in the first data based on a combination of a clustering result 2 and the coding parameter 1, a code length #4 obtained by performing compression coding on the data in the one or more dimensions in the first data based on a combination of the clustering result 2 and the coding parameter 2, a code length #5 obtained by performing compression coding on the data in the one or more dimensions in the first data based on a combination of the clustering result 1 and a coding parameter 3, a code length #6 obtained by performing compression coding on the data in the one or more dimensions in the first data based on a combination of the clustering result 2 and the coding parameter 3, and the like. The clustering result 1 and the clustering result 2 are two assumed clustering results of elements in the first data. One clustering result may include one or more cluster centers, and a correspondence between each element in the first data and the one or more cluster centers. Each element corresponds to only one cluster center. The coding parameter 1, the coding parameter 2, and the coding parameter 3 are three different groups of coding parameters. A quantity of combinations of a clustering result and a coding parameter is not limited. For example, the quantity of combinations of a clustering result and a coding parameter is configured based on a processing capability of the transmitter and a delay requirement of the first data. It should be understood that a larger quantity of code lengths obtained by the transmitter by performing compression coding on the data in the one or more dimensions in the first data based on different combinations of a clustering result and a coding parameter indicates that an optimal combination of a clustering result and a coding parameter is more likely to be obtained, and that a longer time is taken. For another example, the transmitter is preconfigured to determine the plurality of combinations of the clustering result and the coding parameter according to a preset rule. The preset rule is not limited herein.

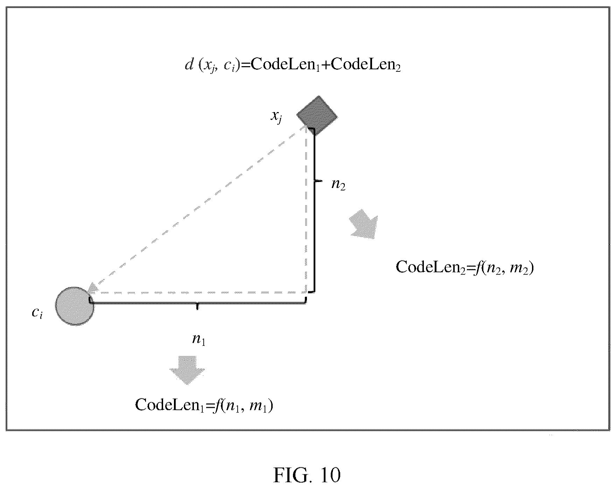

A main principle of the method procedure in FIG. 9 is to determine a better combination of a clustering result and a coding parameter through clustering and entropy coding joint optimization, to improve compression performance. In this embodiment of this application, the function shown in the formula (2) is used as a loss function of a clustering algorithm (a calculation method is shown in FIG. 10 below), and is jointly optimized with the clustering algorithm. FIG. 10 is a diagram of a code length obtained by calculating a compressed two-dimensional difference according to an embodiment of this application. As shown in FIG. 10, $x_j$ represents two-dimensional data, $c_i$ represents one piece of quantized cluster-center data corresponding to the two-dimensional data, $n_1$ represents a difference between first-dimensional data of $x_j$ and first-dimensional data of $c_i$, $n_2$ represents a difference between second-dimensional data of $x_j$ and second-dimensional data of $c_i$, CodeLen$_1$ represents a code length obtained by performing compression coding on $n_1$ based on a coding parameter $m_1$, CodeLen$_2$ represents a code length obtained by performing compression coding on $n_2$ based on a coding parameter $m_2$, $d(x_j, c_i)$ is equal to a sum of CodeLen$_1$ and CodeLen$_2$, and $d(x_j, c_i)$ represents a code length obtained by performing compression coding on a difference between $x_j$ and $c_i$. The transmitter may implement clustering and entropy coding joint optimization in an iterative manner. Iteration steps of the algorithm are similar to those of the k-means algorithm, and may be divided into two steps: assign (Assign) and update (Update).

First step "assign": Assign a cluster center to each data point, where

$$\hat{\imath} = \operatorname*{argmin}_{i}\{d(x_j, c_i)\};$$

Second step "update": Update cluster centers of clusters, where

$$\widehat{c_i} = \underset{c_i}{\arg min} \sum_{\text{assign}(x_j)=i} d(x_j, c_i);$$

The cluster centers may be updated by using gradient descent (the rounding in the expression is ignored). Because the cluster centers further need to be quantized, the update may be alternatively performed through a direct search on quantized grid points. An invariable or a progressively increasing or decreasing quantity of cluster centers may be assigned in the first step.

902: The transmitter determines that a code length obtained by performing compression coding on the data in the one or more dimensions in the first data based on a combination of a first clustering result and a first coding parameter is a shortest one in the plurality of code lengths.

The first clustering result includes k cluster centers, and a correspondence between each element in the first data and the k cluster centers. Each element corresponds to only one cluster center.

903: The transmitter separately quantizes the k cluster centers, to obtain k pieces of quantized cluster-center data and k quantized reconstruction values.

For step 903, refer to step 602.

904: The transmitter performs differencing on each element in the first data and a quantized reconstruction value corresponding to the element, to obtain differential data.

For step 904, refer to step 603.

905: The transmitter quantizes each difference in the differential data to obtain quantized data.

For step 905, refer to step 604.

906: The transmitter performs compression coding on data in one or more dimensions in the quantized data based on the first coding parameter, to obtain one or more pieces of compressed data.

For step 906, refer to step 501.

907: The transmitter sends second data to a receiver.

For step 907, refer to step 502.

908: The receiver separately decodes the one or more pieces of compressed data in the second data based on the first coding parameter, to obtain the first data.

For step 908, refer to step 503.

During each time of data transmission, the transmitter performs (joint) optimization on clustering and a coding parameter, to obtain an optimal parameter m (that is, the first coding data), a clustering result (that is, the first clustering result), and a clustering parameter k. The optimal parameter m is dynamically indicated by using a subscript (indicated by using several bits) of the optimal parameter m in a candidate parameter set. For example, the candidate parameter set is configured for the transmitter and the receiver by using higher layer signaling. For an example of the second data sent by the transmitter to the receiver, refer to FIG. 8.

In this embodiment of this application, the transmitter compresses data in a clustering+entropy coding joint optimization manner, to select an optimal clustering result and an optimal coding parameter. This can improve compression performance.

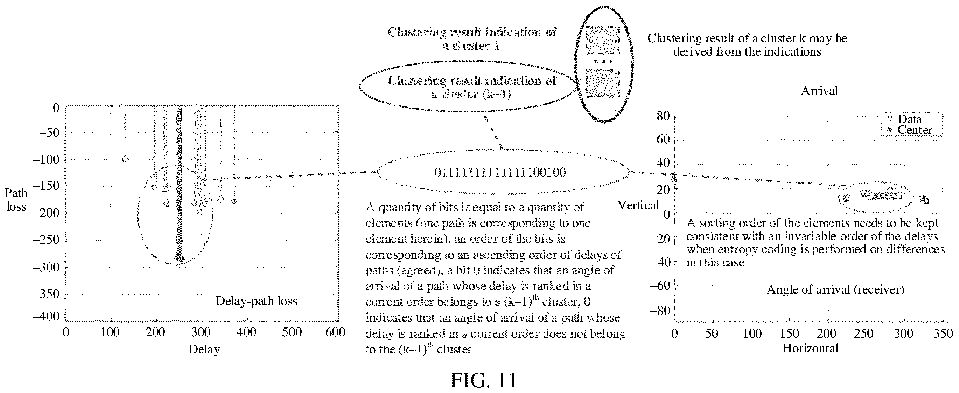

Because data in different dimensions in a high-dimensional vector may satisfy different clustering features, the data in the different dimensions is separately compressed by using a clustering based method (or another method). After decoding the data, the receiver cannot associate data in different dimensions that belong to a same vector. A ray tracing scenario is used as an example. Clustering of angle-of-arrival data may be totally different from clustering of delay or path loss data, and the angle-of-arrival data and the path loss data of a same path need to be one-to-one correspond to each other at the receiver. In this embodiment of this application, an invariable order of one type of data is used as a reference, and data of other types (dimensions) is indicated by one or more bitmaps (bitmaps) and is aligned with specific data. Herein, the angle-of-arrival data in ray tracing is used as an example to indicate a correspondence between an angle of arrival and a delay of each path, so that the angle-of-arrival data and the delay data are one-to-one correspond to each other. A principle is shown in FIG. 11. FIG. 11 shows an example of indication of a correspondence between data in different dimensions according to an embodiment of this application. In FIG. 11, an example is used in which there are 20 paths and a quantity k of cluster centers is equal to 3. As shown in FIG. 11, a quantity of bits in a bit string is equal to a quantity of elements (each path corresponds to one element), an order of the bits corresponds to an ascending order of delays of paths (agreed), a bit 1 indicates that an angle of arrival of a path whose delay is ranked in a current order belongs to a $(k-1)^{\text{th}}$ cluster, a bit 0 indicates that an angle of arrival of a path whose delay is ranked in a current order does not belong to the $(k-1)^{\text{th}}$ cluster, and a sorting order of the elements needs to be kept consistent with an invariable order of the delays (delays) when entropy coding is performed on differences of angles of arrival. In FIG. 11, a bit string (or referred to as a bitmap) represents a cluster (group), and a clustering result indication of a cluster 1, a clustering result indication of a cluster 2, ..., and a clustering result indication of a cluster (k-1) represent different clusters.

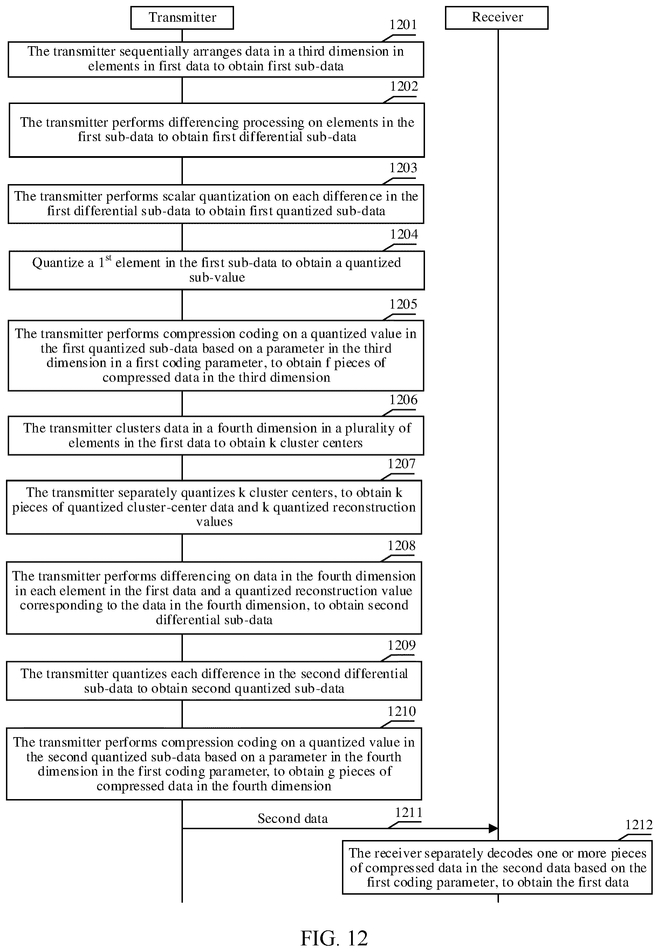

FIG. 12 is a flowchart of another data compression transmission interaction method according to an embodiment of this application. A method procedure in FIG. 12 is a possible implementation of the method described in FIG. 5. As shown in FIG. 12, the method includes the following steps.

1201: A transmitter sequentially arranges data in a third dimension in elements in first data to obtain first sub-data.

In this application, sequential arrangement may be performed in ascending order, or may be performed in descending order.

1202: The transmitter performs differencing processing on elements in the first sub-data to obtain first differential sub-data.

1203: The transmitter performs scalar quantization on each difference in the first differential sub-data to obtain first quantized sub-data.

1204: The transmitter quantizes a $1^{st}$ element in the first sub-data to obtain a quantized sub-value.

1205: The transmitter performs compression coding on a quantized value in the first quantized sub-data based on a parameter in the third dimension in a first coding parameter, to obtain f pieces of compressed data in the third dimension.

1206: The transmitter clusters data in a fourth dimension in a plurality of elements in the first data to obtain k cluster centers.

1207: The transmitter separately quantizes the k cluster centers, to obtain k pieces of quantized cluster-center data and k quantized reconstruction values.

1208: The transmitter performs differencing on data in the fourth dimension in each element in the first data and a quantized reconstruction value corresponding to the data in the fourth dimension, to obtain second differential sub-data.

1209: The transmitter quantizes each difference in the second differential sub-data to obtain second quantized sub-data.

1210: The transmitter performs compression coding on a quantized value in the second quantized sub-data based on a parameter in the fourth dimension in the first coding parameter, to obtain g pieces of compressed data in the fourth dimension.

1211: The transmitter sends second data to a receiver.

The second data includes the f pieces of compressed data in the third dimension, the g pieces of compressed data in the fourth dimension, the quantized sub-value, the k pieces of quantized cluster-center data, and fourth indication information, and the fourth indication information indicates a correspondence between compressed data in the third dimension and compressed data in the fourth dimension. The f pieces of compressed data in the third dimension in the second data are sequentially arranged, the fourth indication information indicates the compressed data in the third dimension corresponding to one or more cluster centers, and an order of entropy-coded data that is in the g pieces of compressed data in the fourth dimension and that corresponds to a same cluster center is the same as an order of data in the third dimension corresponding to the entropy-coded data.

In a possible implementation, the fourth indication information includes a bitmap, a quantity of bits in the bitmap is equal to f, the bits in the bitmap are sequentially corresponding to the f pieces of sequentially arranged compressed data in the third dimension, any bit in the bitmap indicates whether compressed data in the fourth dimension corresponding to compressed data in the third dimension corresponding to the any bit belongs to a first cluster center, and the first cluster center is one of the plurality of cluster centers. The fourth indication information may include a plurality of bitmaps, and different bitmaps are corresponding to different cluster centers. In this implementation, any bit in the bitmap indicates whether compressed data in the fourth dimension corresponding to compressed data in the third dimension corresponding to the any bit belongs to the first cluster center. This can reduce signaling overheads.

1212: The receiver separately decodes one or more pieces of compressed data in the second data based on the first coding parameter, to obtain the first data.

For step 1212, refer to step 503.

In this embodiment of this application, the second data further includes the one or more cluster centers corresponding to the g pieces of compressed data in the fourth dimension, so that a dynamic aggregation feature of the data in the fourth dimension can be effectively utilized for compression. In addition, the fourth indication information indicates the compressed data in the third dimension corresponding to the one or more cluster centers, the f pieces of compressed data in the third dimension in the second data are sequentially arranged, and the order of the entropy-coded data that is in the g pieces of compressed data in the fourth dimension and that corresponds to the same cluster center is the same as the order of the data in the third dimension corresponding to the entropy-coded data. In this way, the receiver can determine the correspondence between compressed data in the third dimension and compressed data in the fourth dimension, and signaling overheads are low.

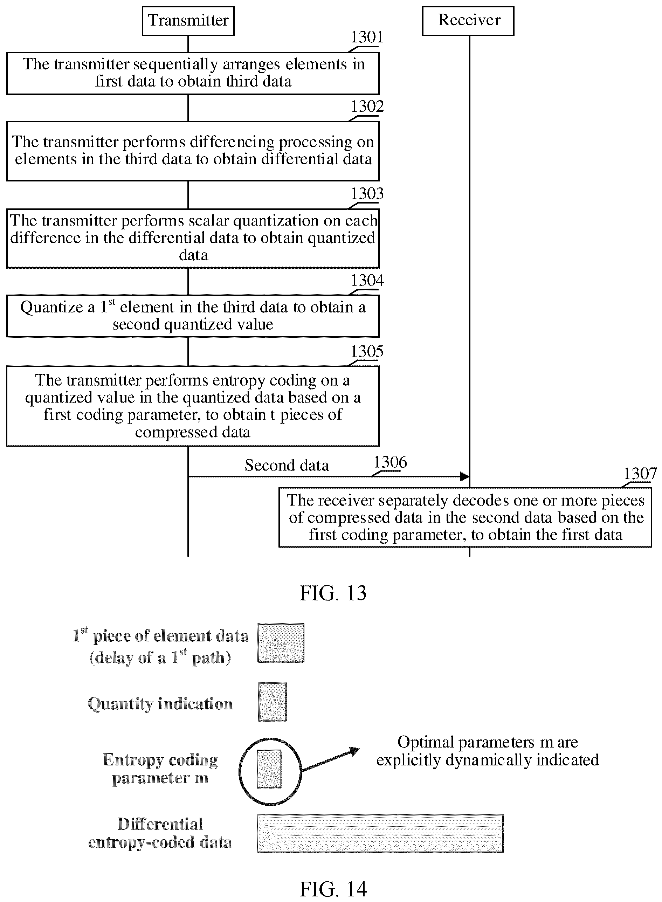

In some cases, clustering effect between one-dimensional vector groups is not obvious, but a spacing between two adjacent elements is small. An embodiment of this application further provides a compression coding scheme for some sortable one-dimensional data. FIG. 13 is a flowchart of another data compression transmission interaction method according to an embodiment of this application. A method procedure in FIG. 13 is a possible implementation of the method described in FIG. 5. As shown in FIG. 13, the method includes the following steps.

1301: A transmitter sequentially arranges elements in first data to obtain third data.

The element in the first data is one-dimensional data.

1302: The transmitter performs differencing processing on elements in the third data to obtain differential data.

1303: The transmitter performs scalar quantization on each difference in the differential data to obtain quantized data.

1304: The transmitter quantizes a 1st element in the third data to obtain a second quantized value.

1305: The transmitter performs entropy coding on a quantized value in the quantized data based on a first coding parameter, to obtain t pieces of compressed data.

1306: The transmitter sends second data to a receiver.

The second data may include the t pieces of compressed data and the second quantized value. The second quantized value is obtained by quantizing minimum or maximum data in the first data. In a possible implementation, the second data further includes fifth indication information, and the fifth indication information indicates t. FIG. 14 shows another example of second data according to an embodiment of this application. As shown in FIG. 14, the second data includes: 1st piece of element data, that is, the second quantized value; a quantity indication (t); an entropy coding parameter m, that is, the first coding parameter; and differential entropy-coded data, that is, the t pieces of compressed data.

1307: The receiver separately decodes one or more pieces of compressed data in the second data based on the first coding parameter, to obtain the first data.

A possible implementation of step 1307 is as follows: separately decoding the one or more pieces of compressed data in the second data based on the first coding parameter, to obtain one or more differences; and adding the one or more differences and a value corresponding to the second quantized value, to obtain the first data.

In this embodiment of this application, differencing is performed on the t pieces of sequentially arranged data, and then the obtained difference is quantized. This can improve compression performance.

The following describes an example of performing compression by using a spatial correlation of data in a broader sense. Ray tracing data is still used as an example. When there is a small quantity of paths, a clustering feature of angle data may not be obvious, and compression effect of the methods described in the foregoing embodiments is undesirable. However, it is observed that when there is a small quantity of paths, a specific spatial correlation still exists between angle data of the paths. For example, angle-of-arrival data in a vertical direction is usually concentrated in a small range, and angles of arrival in a horizontal direction are close to each other. This is mainly caused by a spatial location distribution of strong reflectors in actual physical space. In view of this case, an embodiment of this application proposes a new compression method using a spatial correlation. A core idea is to compress vertical angles of arrival and horizontal angles of arrival separately.

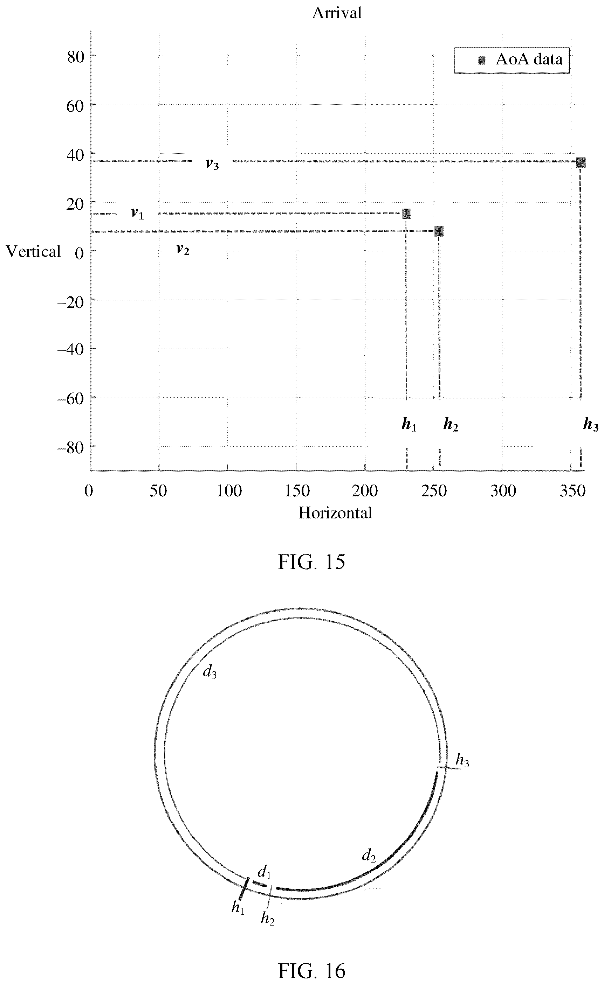

For the horizontal angles of arrival, periodic differencing is first performed by using 360 degrees as a period, and a maximum difference is discarded, and then only remaining differences and original data that ranks first in a difference sequence are retained. Three paths as used an example (angles of arrival are shown in FIG. 15), differential compression of horizontal angles is shown in FIG. 16. In FIG. 16, there are three pieces of horizontal angle-of-arrival data: h1, h2, and h3, circular differences between h1, h2, and h3 are d1, d2, and d3, h1 and the two differences d1 and d2 are finally retained, and d1 and d2 are compressed by using the scalar quantization+entropy coding scheme in the foregoing embodiments. FIG. 15 is a diagram of the angles of arrival of the three paths. FIG. 16 is a diagram of the differential compression of the horizontal angles of arrival.

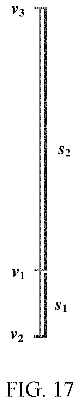

For compression of the angles of arrival in the vertical direction, the angles of arrival are directly arranged in ascending order and then undergo mutual differencing, and only a minimum angle and subsequent differences are finally retained. A principle is shown in FIG. 17. Finally, an angle v2 (that is, the minimum angle) is quantized, and differences s1 and s2 are quantized and compressed through entropy coding. FIG. 17 is a diagram of differential compression of vertical angles of arrival.

Finally, a correspondence between an angle in the horizontal direction and an angle in the vertical direction further needs to be represented and compressed. A full-permutation indication method is used herein. A core idea is to retain a subscript of a to-be-compressed correspondence in a set of all possible correspondences that are arranged in a lexicographic order. Three paths are used as an example. It can be learned that a correspondence between horizontal angles of arrival $(h_1, h_2, h_3)$ and vertical angles of arrival $(v_2, v_1, v_3)$ may be denoted as a full permutation {2, 1, 3}, and in this case, a subscript of {2, 1, 3} in full permutations with a length of 3 that are arranged in a lexicographic order is finally retained. For example, if the full permutations of the three elements are all listed in the lexicographic order: {1, 2, 3}, {1, 3, 2}, {2, 1, 3}, {2, 3, 1}, {3, 1, 2}, {3, 2, 1}, the correspondence {2, 1, 3} ranks third in all the correspondences, and the subscript is 3.

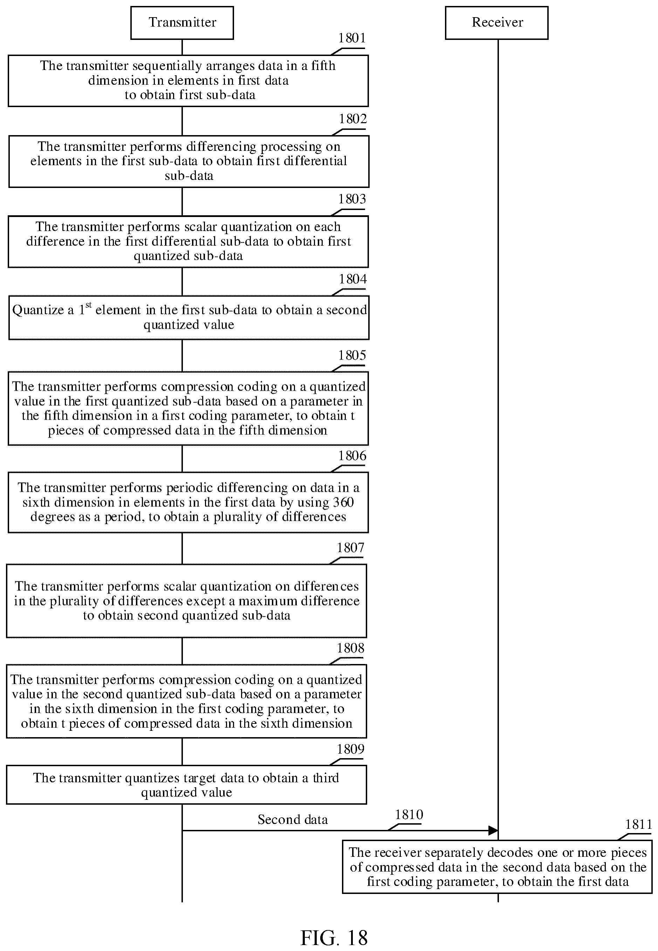

FIG. 18 is a flowchart of another data compression transmission interaction method according to an embodiment of this application. A method procedure in FIG. 18 is a possible implementation of the method described in FIG. 5. As shown in FIG. 18, the method includes the following steps.

1801: A transmitter sequentially arranges data in a fifth dimension in elements in first data to obtain first sub-data.

1802: The transmitter performs differencing processing on elements in the first sub-data to obtain first differential sub-data.

1803: The transmitter performs scalar quantization on each difference in the first differential sub-data to obtain first quantized sub-data.

1804: The transmitter quantizes a $1^{st}$ element in the first sub-data to obtain a second quantized value.

The second quantized value is obtained by quantizing minimum or maximum data in the fifth dimension in the first data.

1805: The transmitter performs compression coding on a quantized value in the first quantized sub-data based on a parameter in the fifth dimension in a first coding parameter, to obtain t pieces of compressed data in the fifth dimension.

1806: The transmitter performs periodic differencing on data in a sixth dimension in elements in the first data by using 360 degrees as a period, to obtain a plurality of differences.

For example, the data in the sixth dimension in the elements in the first data includes h1, h2, and h3, and the circular differences between h1, h2, and h3 are d1, d2, and d3, as shown in FIG. 16. In this example, d1, d2, and d3 are the plurality of differences obtained by performing periodic differencing on the data in the sixth dimension in the elements in the first data by using 360 degrees as a period.

1807: The transmitter performs scalar quantization on differences in the plurality of differences except a maximum difference to obtain second quantized sub-data.

1808: The transmitter performs compression coding on a quantized value in the second quantized sub-data based on a parameter in the sixth dimension in the first coding parameter, to obtain t pieces of compressed data in the sixth dimension.

1809: The transmitter quantizes target data to obtain a third quantized value.

The target data is one of two pieces of data that are in the data in the sixth dimension in the elements in the first data and that yield the maximum difference through differencing.

1810: The transmitter sends second data to a receiver.

The second data may include the obtained t pieces of compressed data in the fifth dimension, the obtained t pieces of compressed data in the sixth dimension, the second quantized value, the third quantized value, and sixth indication information, where the sixth indication information indicates a correspondence between the t pieces of data in the fifth dimension and the t pieces of data in the sixth dimension.

1811: The receiver separately decodes one or more pieces of compressed data in the second data based on the first coding parameter, to obtain the first data.

In this embodiment of this application, the data in the fifth dimension and the data in the sixth dimension in the first data are separately compressed, and compression performance can be improved by using a spatial correlation of data.

The following describes, by using simulation, main beneficial effects of the solutions provided in embodiments of this application.

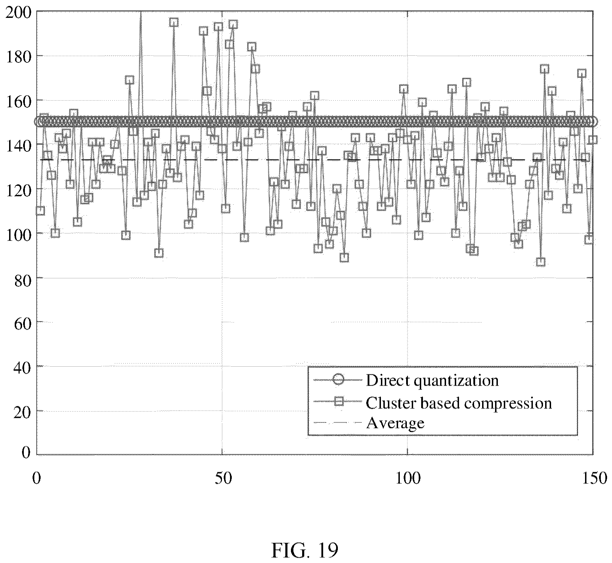

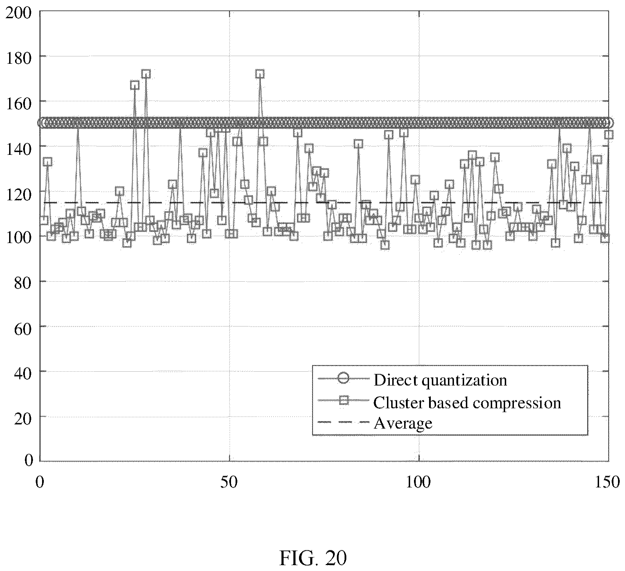

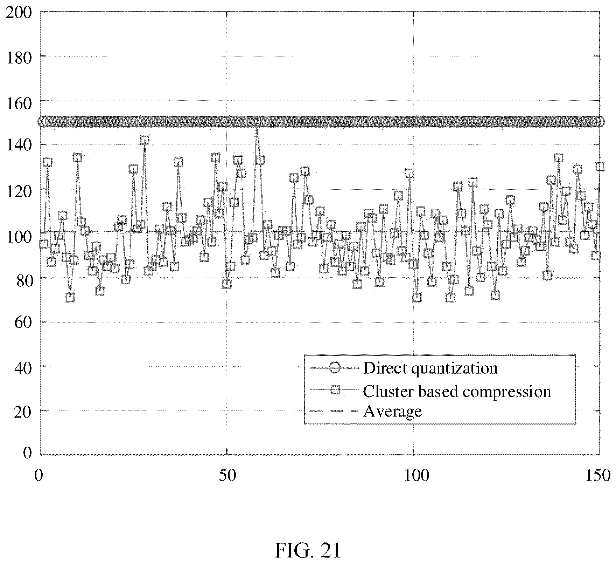

A performance simulation result of compressing angle data in ray tracing of a receiver at 150 random locations is first obtained. In the simulation, only angle-of-arrival data of 10 paths with maximum power is considered, and a reconstruction error of angle data needs to be strictly less than 360/256=1.4063 degrees. FIG. 19, FIG. 20, and FIG. 21 respectively show compression effect of the adaptive arithmetic coding scheme, the Huffman coding scheme, and the clustering+Golomb joint optimization coding scheme that are described above. FIG. 19 shows compression effect of the adaptive arithmetic coding scheme. FIG. 20 shows compression effect of the Huffman coding scheme. FIG. 21 shows compression effect of the clustering+Golomb joint optimization coding scheme (which may be referred to as a joint optimization (joint optimization) scheme for short below). In the figures, horizontal coordinates represent subscripts of data, and there are a total of 150 groups of data in each figure. Vertical coordinates represent volumes of output compressed data. The simulation reference schemes in the figures are all used to quantize each piece of element data based on a specific precision requirement.

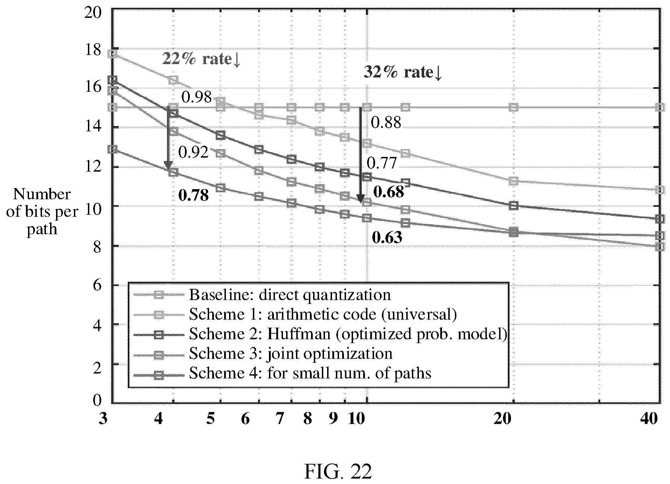

FIG. 22 shows compression effect (mainly compression of different quantities of paths) of schemes with different simulation parameter configurations. It can be learned that an overall trend is that a larger quantity of compressed paths indicates better compression effect. This is because a larger quantity of paths leads to stronger spatial aggregation effect, and accordingly clustering based compression schemes have better performance. FIG. 22 shows compression effect of compressing different quantities of paths. On the contrary, when there is a smaller quantity of paths, spatial aggregation effect is weakened, and overall redundancy is reduced. Consequently, compression effect of the schemes also becomes poorer. In FIG. 22, a reference scheme (baseline) is to quantize each piece of element data directly based on a specific precision requirement; a scheme (scheme) 1 is an adaptive arithmetic coding scheme; a scheme (scheme) 2 is a Huffman coding scheme; a scheme (scheme) 3 is a joint optimization (joint optimization) scheme; and a scheme (scheme) 4 is the compression coding scheme in the method procedure in FIG. 13.

The following describes, with reference to the accompanying drawings, structures of data processing apparatuses (a transmitter and a receiver) that can implement embodiments of this application.

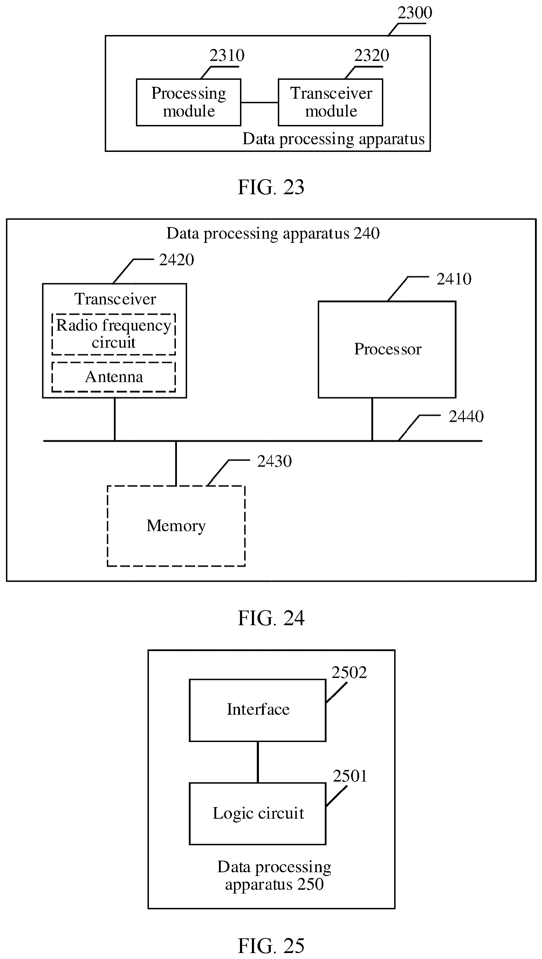

FIG. 23 is a diagram of a structure of a data processing apparatus 2300 according to an embodiment of this application. The data processing apparatus 2300 may correspondingly implement functions or steps implemented by the transmitter in the foregoing method embodiments, or may correspondingly implement functions or steps implemented by the receiver in the foregoing method embodiments. The data processing apparatus may include a processing module 2310 and a transceiver module 2320. Optionally, the data processing apparatus may further include a storage unit. The storage unit may be configured to store instructions (code or a program) and/or data. The processing module 2310 and the transceiver module 2320 may be coupled to the storage unit. For example, the processing module 2310 may read the instructions (the code or the program) and/or the data in the storage unit, to implement a corresponding method. The foregoing units may be independently disposed, or may be partially or completely integrated. For example, the transceiver module 2320 may include a sending module and a receiving module. The sending module may be a transmitter, and the receiving module may be a receiver. An entity corresponding to the transceiver module 2320 may be a transceiver, or may be a communication interface.

In some possible implementations, the data processing apparatus 2300 can correspondingly implement behaviors and the functions of the transmitter in the foregoing method embodiments. For example, the data processing apparatus 2300 may be the transmitter, or may be a component (for example, a chip or a circuit) used in the transmitter. For example, the transceiver module 2320 may be configured to perform all receiving or sending operations performed by the transmitter in the embodiments in FIG. 5, FIG. 6, FIG. 9, FIG. 12, FIG. 13, and FIG. 18, and/or is configured to support other processes of the technologies described in this specification. The processing module 2310 is configured to perform all operations performed by the transmitter in the embodiments in FIG. 5, FIG. 6, FIG. 9, FIG. 12, FIG. 13, and FIG. 18 except the receiving and sending operations.

In some possible implementations, the data processing apparatus 2300 can correspondingly implement behaviors and the functions of the receiver in the foregoing method embodiments. For example, the data processing apparatus 2300 may be the receiver, or may be a component (for example, a chip or a circuit) used in the receiver. For example, the transceiver module 2320 may be configured to perform all receiving or sending operations performed by the receiver in the embodiments in FIG. 5, FIG. 6, FIG. 9, FIG. 12, FIG. 13, and FIG. 18, and/or is configured to support other processes of the technologies described in this specification. For example, the processing module 2310 is configured to perform all operations performed by the receiver in the embodiments in FIG. 5, FIG. 6, FIG. 9, FIG. 12, FIG. 13, and FIG. 18 except the receiving and sending operations.

FIG. 24 is a diagram of a structure of another data processing apparatus 240 according to an embodiment of this application. The data processing apparatus in FIG. 24 may be the foregoing transmitter, or may be the foregoing receiver.

As shown in FIG. 24, the data processing apparatus 240 includes at least one processor 2410 and a transceiver 2420.

In some embodiments of this application, the processor 2410 and the transceiver 2420 may be configured to perform functions, operations, or the like performed by the transmitter. For example, the transceiver 2420 performs all receiving or sending operations performed by the transmitter in the embodiments in FIG. 5, FIG. 6, FIG. 9, FIG. 12, FIG. 13, and FIG. 18, and/or is configured to support other processes of the technologies described in this specification. For example, the processor 2410 is configured to perform all operations performed by the transmitter in the embodiments in FIG. 5, FIG. 6, FIG. 9, FIG. 12, FIG. 13, and FIG. 18 except the receiving and sending operations.

In some embodiments of this application, the processor 2410 and the transceiver 2420 may be configured to perform functions, operations, or the like performed by the receiver. For example, the transceiver 2420 performs all receiving or sending operations performed by the receiver in the embodiments in FIG. 5, FIG. 6, FIG. 9, FIG. 12, FIG. 13, and FIG. 18, and/or is configured to support other processes of the technologies described in this specification. For example, the processor 2410 is configured to perform all operations performed by the receiver in the embodiments in FIG. 5, FIG. 6, FIG. 9, FIG. 12, FIG. 13, and FIG. 18 except the receiving and sending operations.

The transceiver 2420 is configured to communicate with another device/apparatus through a transmission medium. The processor 2410 receives/sends data and/or signaling by using the transceiver 2420, and is configured to implement the methods in the foregoing method embodiments. The processor 2410 may implement functions of the processing module 2310, and the transceiver 2420 may implement functions of the transceiver module 2320.

Optionally, the transceiver 2420 may include a radio frequency circuit and an antenna. The radio frequency circuit is mainly configured to: perform conversion between a baseband signal and a radio frequency signal, and process a radio frequency signal. The antenna is mainly configured to receive and send radio frequency signals in a form of electromagnetic waves. An input/output apparatus, like a touchscreen, a display, or a keyboard, is mainly configured to receive data input by a user and output data to the user.

Optionally, the data processing apparatus 240 may further include at least one memory 2430, configured to store program instructions and/or data. The memory 2430 is coupled to the processor 2410. The coupling in this embodiment of this application may be an indirect coupling or a communication connection between apparatuses, units, or modules in an electrical form, a mechanical form, or another form, and is used for information exchange between the apparatuses, the units, or the modules. The processor 2410 may perform an operation with the memory 2430 cooperatively. The processor 2410 may execute the program instructions stored in the memory 2430. At least one of the at least one memory may be included in the processor.

After the data processing apparatus 240 is powered on, the processor 2410 may read a software program in the memory 2430, interpret and execute instructions of the software program, and process data of the software program. When data needs to be sent wirelessly, the processor 2410 performs baseband processing on the to-be-sent data, and then outputs a baseband signal to the radio frequency circuit. The radio frequency circuit performs radio frequency processing on the baseband signal, and then sends out a radio frequency signal in a form of an electromagnetic wave through the antenna. When data is sent to the data processing apparatus, the radio frequency circuit receives a radio frequency signal through the antenna, converts the radio frequency signal into a baseband signal, and outputs the baseband signal to the processor 2410. The processor 2410 converts the baseband signal into data and processes the data.

In another implementation, the radio frequency circuit and the antenna may be disposed independently of the processor that performs baseband processing. For example, in a distributed scenario, the radio frequency circuit and the antenna may be remotely disposed independently of the data processing apparatus.

A specific connection medium between the transceiver 2420, the processor 2410, and the memory 2430 is not limited in embodiment of this application. In this embodiment of this application, the memory 2430, the processor 2410, and the transceiver 2420 are connected through a bus 2440 in FIG. 24. The bus is represented by a bold line in FIG. 24. This is merely an example for description and does not constitute any limitation. There may be other connection modes between the components. The bus may be classified into an address bus, a data bus, a control bus, and the like. For ease of representation, the bus is represented by using only one bold line in FIG. 24, but this does not mean that there is only one bus or one type of bus.

In this embodiment of this application, the processor may be a general-purpose processor, a digital signal processor, an application-specific integrated circuit, a field programmable gate array, another programmable logic device, a discrete gate, a transistor logic device, or a discrete hardware component, and can implement or execute the methods, steps, and logical block diagrams disclosed in embodiments of this application. The general-purpose processor may be a microprocessor, any conventional processor, or the like. The steps of the methods disclosed with reference to embodiments of this application may be directly implemented by a hardware processor, or may be implemented by a combination of hardware in the processor and a software module.

FIG. 25 is a diagram of a structure of another data processing apparatus 250 according to an embodiment of this application. As shown in FIG. 25, the data processing apparatus shown in FIG. 25 includes a logic circuit 2501 and an interface 2502. The processing module 2310 in FIG. 23 may be implemented by the logic circuit 2501, and the transceiver module 2320 in FIG. 23 may be implemented by the interface 2502. The logic circuit 2501 may be a chip, a processing circuit, an integrated circuit, a system on chip (system on chip, SoC), or the like. The interface 2502 may be a communication interface, an input/output interface, or the like. In this embodiment of this application, the logic circuit and the interface may be further coupled to each other. A specific connection mode between the logic circuit and the interface is not limited in embodiments of this application.

In some embodiments of this application, the logic circuit and the interface may be configured to perform functions, operations, or the like performed by the transmitter.

In some embodiments of this application, the logic circuit and the interface may be configured to perform functions, operations, or the like performed by the receiver.

This application further provides a computer-readable storage medium. The computer-readable storage medium stores a computer program or instructions. When the computer program or instructions are run on a computer, the computer is enabled to perform the methods in the foregoing embodiments. The computer-readable storage medium may be any usable medium accessible to a computer, or a data storage device, like a server or a data center, integrating one or more usable media. The usable medium may be a magnetic medium (for example, a floppy disk, a hard disk, or a magnetic tape), an optical medium (for example, a DVD), a semiconductor medium (for example, a solid state disk (solid state disk, SSD)), or the like. The computer may be a general-purpose computer, a dedicated computer, a computer network, or another programmable apparatus.

It should be noted that a person of ordinary skill in the art can learn that all or some of the steps of the methods in the foregoing embodiments may be implemented by a program instructing related hardware. The program may be stored in the computer-readable storage medium. The computer-readable storage medium includes a read-only memory (read-only memory, ROM), a random access memory (random access memory, RAM), a programmable read-only memory (programmable read-only memory, PROM), an erasable programmable read-only memory (erasable programmable read-only memory, EPROM), a one-time programmable read-only memory (one-time programmable read-only memory, OTPROM), an electrically erasable programmable read-only memory (Electrically Erasable Programmable Read-Only Memory, EEPROM), a compact disc read-only memory (Compact Disc read-only memory, CD-ROM), another optical disc memory, a magnetic disk memory, a magnetic tape memory, or any other computer-readable medium capable of carrying or storing data.

This application further provides a computer program product. The computer program product includes instructions or a computer program. When the instructions or computer program is run on a computer, the methods in the foregoing embodiments are performed. The computer program product includes one or more computer instructions. When the computer program instructions are loaded and executed on a computer, all or some of the procedures or functions according to embodiments of this application are generated.

All or some of the foregoing embodiments may be implemented by using software, hardware, firmware, or any combination thereof. When software is used to implement the foregoing embodiments, all or some of the foregoing embodiments may be implemented in a form of a computer program product.

This application further provides a communication system, including the foregoing transmitter and the foregoing receiver.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A data compression method, comprising:

   performing compression coding on data in one or more dimensions in first data based on a first coding parameter, to obtain one or more pieces of compressed data; and
   sending second data, wherein the second data comprises the compressed data and first indication information, and the first indication information indicates the first coding parameter; wherein
   the first coding parameter satisfies a target condition, the target condition is that a code length obtained by performing compression coding on the data in the one or more dimensions in the first data based on the first coding parameter is a shortest one in a plurality of code lengths, the plurality of code lengths comprise code lengths obtained by performing compression coding on the data in the one or more dimensions in the first data separately based on a plurality of groups of coding parameters, and the plurality of groups of coding parameters comprise the first coding parameter.

2. The method according to claim 1, wherein the second data further comprises k pieces of quantized cluster-center data, at least one of the one or more pieces of compressed data corresponds to one of the k pieces of quantized cluster-center data, and k is an integer greater than or equal to 1.

3. The method according to claim 2, wherein the second data further comprises second indication information, and the second indication information identifies a correspondence between the k pieces of quantized cluster-center data and the one or more pieces of compressed data.

4. The method according to claim 2 or 3, wherein the second data further comprises third indication information, and the third indication information indicates k.

5. The method according to any one of claims 2 to 4, wherein the second data comprises first coding information and second coding information, the first coding information comprises data in a first dimension in the one or more pieces of compressed data, the second coding information comprises data in a second dimension in the one or more pieces of compressed data, the data in the first dimension in the one or more pieces of compressed data is obtained by performing compression coding based on data in the first dimension in the first data and a coding parameter in the first dimension in the first coding parameter, and the data in the second dimension in the one or more pieces of compressed data is obtained by performing compression coding based on data in the second dimension in the first data and a coding parameter in the second dimension in the first coding parameter.

6. The method according to claim 1, wherein the one or more pieces of compressed data comprise f pieces of compressed data in a third dimension and g pieces of compressed data in a fourth dimension, the f pieces of compressed data in the third dimension and the g pieces of compressed data in the fourth dimension are obtained by using different compression coding schemes, and f and g are integers greater than 0.

7. The method according to claim 6, wherein the second data further comprises fourth indication information, and the fourth indication information indicates a correspondence between compressed data in the third dimension and compressed data in the fourth dimension.

8. The method according to claim 7, wherein the second data further comprises one or more cluster centers corresponding to the g pieces of compressed data in the fourth dimension, the f pieces of compressed data in the third dimension in the second data are sequentially arranged, the fourth indication information indicates the compressed data in the third dimension corresponding to the one or more cluster centers, and an order of entropy-coded data that is in the g pieces of compressed data in the fourth dimension and that corresponds to a same cluster center is the same as an order of data in the third dimension corresponding to the entropy-coded data.

9. A data decompression method, comprising:

   receiving second data, wherein the second data comprises one or more pieces of compressed data and first indication information, the first indication information indicates a first coding parameter, the first coding parameter satisfies a target condition, the target condition is that a code length obtained by performing compression coding on data in one or more dimensions in first data based on the first coding parameter is a shortest one in a plurality of code lengths, the plurality of code lengths comprise code lengths obtained by performing compression coding on the data in the one or more dimensions in the first data separately based on a plurality of groups of coding parameters, and the plurality of groups of coding parameters comprise the first coding parameter; and
   decoding the compressed data in the second data based on the first coding parameter, to obtain the first data.

10. The method according to claim 9, wherein the second data further comprises k pieces of quantized cluster-center data, at least one of the one or more pieces of compressed data corresponds to one of the k pieces of quantized cluster-center data, and k is an integer greater than or equal to 1.

11. The method according to claim 10, wherein the second data further comprises second indication information, and the second indication information identifies a correspondence between the k pieces of quantized cluster-center data and the one or more pieces of compressed data.

12. The method according to claim 10 or 11, wherein the second data further comprises third indication information, and the third indication information indicates k.

13. The method according to any one of claims 10 to 12, wherein the second data comprises first coding information and second coding information, the first coding information comprises data in a first dimension in the one or more pieces of compressed data, the second coding information comprises data in a second dimension in the one or more pieces of compressed data, the data in the first dimension in the one or more pieces of compressed data is obtained by performing compression coding based on data in the first dimension in the first data and a coding parameter in the first dimension in the first coding parameter, and the data in the second dimension in the one or more pieces of compressed data is obtained by performing compression coding based on data in the second dimension in the first data and a coding parameter in the second dimension in the first coding parameter.

14. The method according to claim 9, wherein the one or more pieces of compressed data comprise f pieces of compressed data in a third dimension and g pieces of compressed data in a fourth dimension, the f pieces of compressed data in the third dimension and the g pieces of compressed data in the fourth dimension are obtained by using different compression coding schemes, and f and g are integers greater than 0.

15. The method according to claim 14, wherein the second data further comprises fourth indication information, and the fourth indication information indicates a correspondence between compressed data in the third dimension and compressed data in the fourth dimension.

16. The method according to claim 15, wherein the second data further comprises one or more cluster centers corresponding to the g pieces of compressed data in the fourth dimension, the f pieces of compressed data in the third dimension in the second data are sequentially arranged, the fourth indication information indicates the compressed data in the third dimension corresponding to the one or more cluster centers, and an order of entropy-coded data that is in the g pieces of compressed data in the fourth dimension and that corresponds to a same cluster center is the same as an order of data in the third dimension corresponding to the entropy-coded data.

17. A data processing apparatus, comprising:

a processing module, configured to perform compression coding on data in one or more dimensions in first data based on a first coding parameter, to obtain one or more pieces of compressed data; and

a transceiver module, configured to send second data, wherein the second data comprises the compressed data and first indication information, and the first indication information indicate the first coding parameter; wherein the first coding parameter satisfies a target condition, the target condition is that a code length obtained by performing compression coding on the data in the one or more dimensions in the first data based on the first coding parameter is a shortest one in a plurality of code lengths, the plurality of code lengths comprise code lengths obtained by performing compression coding on the data in the one or more dimensions in the first data separately based on a plurality of groups of coding parameters, and the plurality of groups of coding parameters comprise the first coding parameter.

18. The apparatus according to claim 17, wherein the second data further comprises k pieces of quantized cluster-center data, at least one of the one or more pieces of compressed data corresponds to one of the k pieces of quantized cluster-center data, and k is an integer greater than or equal to 1.

19. The apparatus according to claim 18, wherein the second data further comprises second indication information, and the second indication information identifies a correspondence between the k pieces of quantized cluster-center data and the one or more pieces of compressed data.

20. The apparatus according to claim 18 or 19, wherein the second data further comprises third indication information, and the third indication information indicates k.

21. The apparatus according to any one of claims 18 to 20, wherein the second data comprises first coding information and second coding information, the first coding information comprises data in a first dimension in the one or more pieces of compressed data, the second coding information comprises data in a second dimension in the one or more pieces of compressed data, the data in the first dimension in the one or more pieces of compressed data is obtained by performing compression coding based on data in the first dimension in the first data and a coding parameter in the first dimension in the first coding parameter, and the data in the second dimension in the one or more pieces of compressed data is obtained by performing compression coding based on data in the second dimension in the first data and a coding parameter in the second dimension in the first coding parameter.

22. The apparatus according to claim 17, wherein the one or more pieces of compressed data comprise f pieces of compressed data in a third dimension and g pieces of compressed data in a fourth dimension, the f pieces of compressed data in the third dimension and the g pieces of compressed data in the fourth dimension are obtained by using different compression coding schemes, and f and g are integers greater than 0.

23. The apparatus according to claim 22, wherein the second data further comprises fourth indication information, and the fourth indication information indicates a correspondence between compressed data in the third dimension and compressed data in the fourth dimension.

24. The apparatus according to claim 23, wherein the second data further comprises one or more cluster centers corresponding to the g pieces of compressed data in the fourth dimension, the f pieces of compressed data in the third dimension in the second data are sequentially arranged, the fourth indication information indicates the compressed data in the third dimension corresponding to the one or more cluster centers, and an order of entropy-coded data that is in the g pieces of compressed data in the fourth dimension and that corresponds to a same cluster center is the same as an order of data in the third dimension corresponding to the entropy-coded data.

25. A data processing apparatus, comprising:

a transceiver module, configured to receive second data, wherein the second data comprises one or more pieces of compressed data and first indication information, the first indication information indicates a first coding parameter, the first coding parameter satisfies a target condition, the target condition is that a code length obtained by performing compression coding on data in one or more dimensions in first data based on the first coding parameter is a shortest one in a plurality of code lengths, the plurality of code lengths comprise code lengths obtained by performing compression coding on the data in the one or more dimensions in the first data separately based on a plurality of groups of coding parameters, and the plurality of groups of coding parameters comprise the first coding parameter; and

a processing module, configured to decode the compressed data in the second data based on the first entropy coding parameter, to obtain the first data.

26. The apparatus according to claim 25, wherein the second data further comprises k pieces of quantized cluster-center data, at least one of the one or more pieces of compressed data corresponds to one of the k pieces of quantized cluster-center data, and k is an integer greater than or equal to 1.

27. The apparatus according to claim 26, wherein the second data further comprises second indication information, and the second indication information identifies a correspondence between the k pieces of quantized cluster-center data and the one or more pieces of compressed data.

28. The apparatus according to claim 26 or 27, wherein the second data further comprises third indication information, and the third indication information indicates k.

29. The apparatus according to any one of claims 26 to 28, wherein the second data comprises first coding information and second coding information, the first coding information comprises data in a first dimension in the one or more pieces of compressed data, the second coding information comprises data in a second dimension in the one or more pieces of compressed data, the data in the first dimension in the one or more pieces of compressed data is obtained by performing compression coding based on data in the first dimension in the first data and a coding parameter in the first dimension in the first coding parameter, and the data in the second dimension in the one or more pieces of compressed data is obtained by performing compression coding based on data in the second dimension in the first data and a coding parameter in the second dimension in the first coding parameter.

30. The apparatus according to claim 25, wherein the one or more pieces of compressed data comprise f pieces of compressed data in a third dimension and g pieces of compressed data in a fourth dimension, the f pieces of compressed data in the third dimension and the g pieces of compressed data in the fourth dimension are obtained by using different compression coding schemes, and f and g are integers greater than 0.

31. The apparatus according to claim 30, wherein the second data further comprises fourth indication information, and the fourth indication information indicates a correspondence between compressed data in the third dimension and compressed data in the fourth dimension.

32. The apparatus according to claim 31, wherein the second data further comprises one or more cluster centers corresponding to the g pieces of compressed data in the fourth dimension, the f pieces of compressed data in the third dimension in the second data are sequentially arranged, the fourth indication information indicates the compressed data in the third dimension corresponding to the one or more cluster centers, and an order of entropy-coded data that is in the g pieces of compressed data in the fourth dimension and that corresponds to a same cluster center is the same as an order of data in the third dimension corresponding to the entropy-coded data.

33. A computer-readable storage medium, wherein the computer-readable storage medium stores a computer program, the computer program comprises program instructions, and when the program instructions are executed, a computer is enabled to perform the method according to any one of claims 1 to 8; or when the program instructions are executed, a computer is enabled to perform the method according to any one of claims 9 to 16.

34. A communication apparatus, comprising a processor, wherein the processor is configured to: when executing instructions, enable the communication apparatus to perform the method according to any one of claims 1 to 8, or enable the communication apparatus to perform the method according to any one of claims 9 to 16.

35. The apparatus according to claim 34, wherein the apparatus further comprises a memory, and the memory is configured to store the instructions.

36. A communication system, comprising a communication apparatus according to any one of claims 17 to 24 and a communication apparatus according to any one of claims 25 to 32.

37. A computer program product, wherein the computer program product comprises a computer program, the computer program comprises program instructions, and when the program instructions are executed, a computer is enabled to perform the method according to any one of claims 1 to 16.

38. A chip, comprising:

a communication interface, configured to receive and send signals of the chip; and
a processor, configured to execute computer program instructions, so that a data processing apparatus comprising the chip performs the method according to any one of claims 1 to 16.

FIG. 1

FIG. 2

FIG. 3

FIG. 4

| Transmitter | | Receiver |

501

The transmitter performs compression coding on data in one or more dimensions in first data based on a first coding parameter, to obtain one or more pieces of compressed data

Second data                    502

503

The receiver separately decodes the one or more pieces of compressed data in the second data based on the first coding parameter, to obtain the first data

FIG. 5

Transmitter | Receiver

601

The transmitter clusters elements in first data to obtain k cluster centers

602

The transmitter separately quantizes the k cluster centers, to obtain k pieces of quantized cluster-center data and k quantized reconstruction values

603

Perform differencing on each element in the first data and a quantized reconstruction value corresponding to the element, to obtain differential data

604

The transmitter quantizes each difference in the differential data to obtain quantized data

605

The transmitter determines, based on the quantized data, a first coding parameter used to perform compression coding on the first data

606

The transmitter performs compression coding on data in one or more dimensions in the quantized data based on the first coding parameter, to obtain one or more pieces of compressed data

Second data    607

608

The receiver separately decodes the one or more pieces of compressed data in the second data based on the first coding parameter, to obtain the first data

FIG. 6

FIG. 7

When entropy coding is performed on differential data, a sorting order of data with different clusters needs to be kept consistent with an order of cluster-center data

Quantity indication of each cluster

Clustering parameter k

Cluster-center data

| AoD | AoA | Center 1
| AoD | AoA | Center 2
...
| AoD | AoA | Center k

Parameter m1
Parameter m2
Parameter m3
Parameter m4

AoD horizontal

AoD vertical

AoA horizontal

AoA vertical

One or more pieces of compressed data

Optimal parameters m are explicitly dynamically indicated

FIG. 8

EP 4 672 724 A1

Transmitter

Receiver

901

Obtain a plurality of code lengths obtained by performing compression coding on data in one or more dimensions in first data based on a plurality of combinations of a clustering result and a coding parameter

902

The transmitter determines that a code length obtained by performing compression coding on the data in the one or more dimensions in the first data based on a combination of a first clustering result and a first coding parameter is a shortest code length among the plurality of code lengths

903

The transmitter separately quantizes k cluster centers, to obtain k pieces of quantized cluster-center data and k quantized reconstruction values

904

The transmitter performs differencing on each element in the first data and a quantized reconstruction value corresponding to the element, to obtain differential data

905

The transmitter quantizes each difference in the differential data to obtain quantized data

906

The transmitter performs compression coding on data in one or more dimensions in the quantized data based on the first coding parameter, to obtain one or more pieces of compressed data

Second data          907

908

The receiver separately decodes the one or more pieces of compressed data in the second data based on the first coding parameter, to obtain the first data

FIG. 9

$$d\,(x_j,\ c_i) = \text{CodeLen}_1 + \text{CodeLen}_2$$

$x_j$

$n_2$

$c_i$

$\text{CodeLen}_2 = f(n_2,\ m_2)$

$n_1$

$\text{CodeLen}_1 = f(n_1,\ m_1)$

FIG. 10

Clustering result indication of a cluster 1

Clustering result indication of a cluster (k−1)

Clustering result of a cluster k may be derived from the indications

0111111111111111100100

A quantity of bits is equal to a quantity of elements (one path is corresponding to one element herein), an order of the bits is corresponding to an ascending order of delays of paths (agreed), a bit 0 indicates that an angle of arrival of a path whose delay is ranked in a current order belongs to a $(k-1)^{th}$ cluster, 0 indicates that an angle of arrival of a path whose delay is ranked in a current order does not belong to the $(k-1)^{th}$ cluster

A sorting order of the elements needs to be kept consistent with an invariable order of the delays when entropy coding is performed on differences in this case

Path loss

Delay-path loss

Delay

Arrival

Data
Center

Vertical

Angle of arrival (receiver)

Horizontal

FIG. 11

EP 4 672 724 A1

| Transmitter | | Receiver |
|---|---|---|

1201

The transmitter sequentially arranges data in a third dimension in elements in first data to obtain first sub-data

1202

The transmitter performs differencing processing on elements in the first sub-data to obtain first differential sub-data

1203

The transmitter performs scalar quantization on each difference in the first differential sub-data to obtain first quantized sub-data

1204

Quantize a $1^{st}$ element in the first sub-data to obtain a quantized sub-value

1205

The transmitter performs compression coding on a quantized value in the first quantized sub-data based on a parameter in the third dimension in a first coding parameter, to obtain f pieces of compressed data in the third dimension

1206

The transmitter clusters data in a fourth dimension in a plurality of elements in the first data to obtain k cluster centers

1207

The transmitter separately quantizes k cluster centers, to obtain k pieces of quantized cluster-center data and k quantized reconstruction values

1208

The transmitter performs differencing on data in the fourth dimension in each element in the first data and a quantized reconstruction value corresponding to the data in the fourth dimension, to obtain second differential sub-data

1209

The transmitter quantizes each difference in the second differential sub-data to obtain second quantized sub-data

1210

The transmitter performs compression coding on a quantized value in the second quantized sub-data based on a parameter in the fourth dimension in the first coding parameter, to obtain g pieces of compressed data in the fourth dimension

Second data          1211

1212

The receiver separately decodes one or more pieces of compressed data in the second data based on the first coding parameter, to obtain the first data

FIG. 12

| Transmitter | | Receiver |
|---|---|---|

1301

The transmitter sequentially arranges elements in first data to obtain third data

1302

The transmitter performs differencing processing on elements in the third data to obtain differential data

1303

The transmitter performs scalar quantization on each difference in the differential data to obtain quantized data

1304

Quantize a $1^{st}$ element in the third data to obtain a second quantized value

1305

The transmitter performs entropy coding on a quantized value in the quantized data based on a first coding parameter, to obtain t pieces of compressed data

Second data 1306

1307

The receiver separately decodes one or more pieces of compressed data in the second data based on the first coding parameter, to obtain the first data

FIG. 13

$1^{st}$ piece of element data
(delay of a $1^{st}$ path)

Quantity indication

Entropy coding parameter m

Optimal parameters m are explicitly dynamically indicated

Differential entropy-coded data

FIG. 14

Arrival

FIG. 15

FIG. 16

FIG. 17

Transmitter | Receiver

1801

The transmitter sequentially arranges data in a fifth dimension in elements in first data to obtain first sub-data

1802

The transmitter performs differencing processing on elements in the first sub-data to obtain first differential sub-data

1803

The transmitter performs scalar quantization on each difference in the first differential sub-data to obtain first quantized sub-data

1804

Quantize a $1^{st}$ element in the first sub-data to obtain a second quantized value

1805

The transmitter performs compression coding on a quantized value in the first quantized sub-data based on a parameter in the fifth dimension in a first coding parameter, to obtain t pieces of compressed data in the fifth dimension

1806

The transmitter performs periodic differencing on data in a sixth dimension in elements in the first data by using 360 degrees as a period, to obtain a plurality of differences

1807

The transmitter performs scalar quantization on differences in the plurality of differences except a maximum difference to obtain second quantized sub-data

1808

The transmitter performs compression coding on a quantized value in the second quantized sub-data based on a parameter in the sixth dimension in the first coding parameter, to obtain t pieces of compressed data in the sixth dimension

1809

The transmitter quantizes target data to obtain a third quantized value

Second data          1810

1811

The receiver separately decodes one or more pieces of compressed data in the second data based on the first coding parameter, to obtain the first data

FIG. 18

FIG. 19

FIG. 20

FIG. 21

FIG. 22

2300

2310                              2320

| Processing module | | Transceiver module |

Data processing apparatus

FIG. 23

Data processing apparatus 240

2420

Transceiver

Radio frequency circuit

Antenna

2410

Processor

2440

2430

Memory

FIG. 24

2502

Interface

2501

Logic circuit

Data processing apparatus 250

FIG. 25

## INTERNATIONAL SEARCH REPORT

| | International application No. |
|---|---|
| | **PCT/CN2023/089066** |

| A. | CLASSIFICATION OF SUBJECT MATTER |
|---|---|
| | H04L 69/04(2022.01)i |

According to International Patent Classification (IPC) or to both national classification and IPC

| B. | FIELDS SEARCHED |
|---|---|

Minimum documentation searched (classification system followed by classification symbols)

IPC: H04L H04W H04N H04B

Documentation searched other than minimum documentation to the extent that such documents are included in the fields searched

Electronic data base consulted during the international search (name of data base and, where practicable, search terms used)

DWPI, CNTXT, ENTXTC, CNKI, 3GPP: 多维, 聚类中心, 射线追踪, 码长, 短, 压缩, 编码, 指示, Golomb, Rice, ray tracing, multiple, dimension, code, length, short, compress, encode, indicate

| C. | DOCUMENTS CONSIDERED TO BE RELEVANT |
|---|---|

| Category* | Citation of document, with indication, where appropriate, of the relevant passages | Relevant to claim No. |
|---|---|---|
| X | CN 102215385 A (SHENYANG INSTITUTE OF AUTOMATION, CHINESE ACADEMY OF SCIENCES) 12 October 2011 (2011-10-12)<br>claims 1 and 4 | 1-38 |
| X | CN 113143284 A (ZHEJIANG UNIVERSITY) 23 July 2021 (2021-07-23)<br>entire document | 1-38 |
| A | US 10565773 B1 (NOKIA TECHNOLOGIES OY) 18 February 2020 (2020-02-18)<br>entire document | 1-38 |
| A | CN 108282662 A (WUHAN JINGCE ELECTRONIC GROUP CO., LTD.) 13 July 2018 (2018-07-13)<br>entire document | 1-38 |

☐ Further documents are listed in the continuation of Box C.   ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **07 December 2023** | **18 December 2023** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

| Patent document cited in search report | | | Publication date (day/month/year) | Patent family member(s) | Publication date (day/month/year) |
|---|---|---|---|---|---|
| CN | 102215385 | A | 12 October 2011 | None | |
| CN | 113143284 | A | 23 July 2021 | None | |
| US | 10565773 | B1 | 18 February 2020 | None | |
| CN | 108282662 | A | 13 July 2018 | None | |

Form PCT/ISA/210 (patent family annex) (July 2022)